Europäisches Patentamt

European Patent Office

Office européen des brevets

(19)

(11) EP 0 896 426 A1

(12) DEMANDE DE BREVET EUROPEEN

(43) Date de publication:
10.02.1999 Bulletin 1999/06

(51) Int Cl.⁶: H03F 1/32

(21) Numéro de dépôt: 98401958.8

(22) Date de dépôt: 30.07.1998

(84) Etats contractants désignés:
AT BE CH CY DE DK ES FI FR GB GR IE IT LI LU
MC NL PT SE
Etats d'extension désignés:
AL LT LV MK RO SI

(30) Priorité: 01.08.1997 FR 9710052

(71) Demandeur: FRANCE TELECOM SA
75015 Paris (FR)

(72) Inventeurs:
• Meghdadi, Vahid
83000 Toulon (FR)

• Cances, Jean-Pierre
83000 Toulon (FR)
• Chevallier, François-René
83000 Toulon (FR)
• Dumas, Jean-Michel
83000 Toulon (FR)

(74) Mandataire: Ballot, Paul Denis Jacques
Cabinet Ballot-Schmit,
9, boulevard de Strasbourg
83000 Toulon (FR)

(54) **Procédé de simulation d'amplificateur non-linéaire à mémoire d'enveloppe**

(57) L'invention concerne un procédé de simulation de réponse d'amplificateur non-linéaire.
Selon l'invention, il est prévu de :

- mesurer des caractéristiques de non-linéarité d'amplitude et de conversion amplitude/déphasage de l'amplificateur, chaque mesure étant effectué à amplitude constante en entrée,
- mesurer les caractéristiques à différentes fréquences,
- développer les caractéristiques en suite de fonctions de transfert directes, et
- calculer des correcteurs en fréquence pour les fonctions de transfert directes,
- mesurer des caractéristiques de distorsion de modulation d'amplitude, chaque mesure étant effectuée en modulant l'amplitude d'entrée,
- calculer des fonctions (E) de transfert de modulation reproduisant en sortie (m) les amplitudes de distorsion selon les amplitudes de modulation d'entrée (x) et corrigeant les fonctions de transfert directes (MM) lorsque l'amplitude d'entrée (x) est modulée, afin de simuler l'effet de mémoire d'enveloppe.

Application au domaine de la simulation de l'amplification hyperfréquence à haut rendement.

## FIG.23

## Description

La présente invention concerne le domaine de la simulation de réponse en signal d'amplificateurs non linéaires et a pour objet un système de simulation du signal de réponse d'un amplificateur non-linéaire présentant un effet de mémoire.

Une application d'un tel système est la simulation de l'amplification hyperfréquence à haut rendement, notamment en classe AB, B ou C d'amplification et plus particulièrement la simulation de réponse d'amplificateurs de puissance à l'état solide, de type SSPA, et de dispositifs amplificateurs à base de tubes à ondes progressives, de type TOP ou TWT, utilisés dans les liaisons de transmission par faisceau hertzien terrestre ou satellite.

A haute fréquence et à haut rendement, de tels dispositifs amplificateurs présentent une caractéristique de réponse non-linéaire.

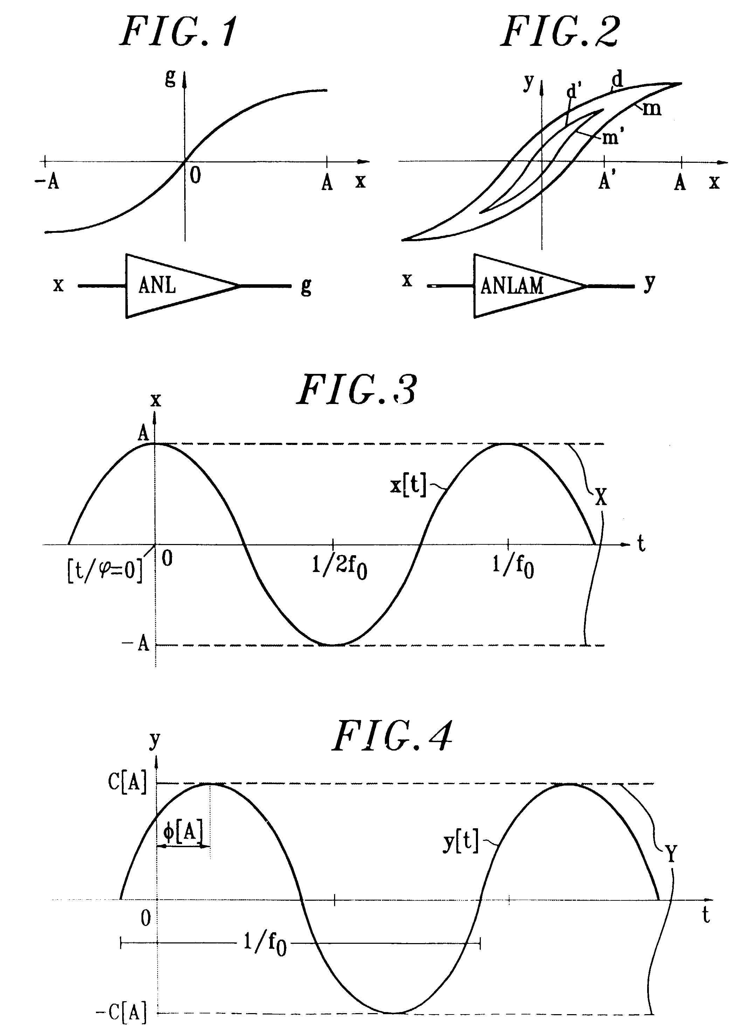

La figure 1 illustre un exemple de courbe de réponse entrée-sortie d'amplificateur non-linéaire ANL. La courbe donnant le niveau de signal de sortie g de l'amplificateur ANL en fonction du niveau de signal d'entrée x est typiquement infléchie aux fortes amplitudes A du signal d'entrée x, à cause de phénomènes de saturation. Lorsque l'amplificateur est utilisé dans des conditions telles que le gain n'est pas constant en fonction du niveau de signal d'entrée x, on parle d'amplificateur fonctionnant en régime non-linéaire ou plus simplement d'amplification non-linéaire.

Parmi les dispositifs non-linéaires, on distingue des dispositifs sans mémoire, quasi-sans-mémoire et à mémoire.

Les amplificateurs sans mémoire présentent une forte non-linéarité en amplitude et une moindre distorsion de phase. La caractéristique de réponse entrée/sortie d'un amplificateur sans mémoire ANL peut alors se réduire, comme illustré figure 1, à une seule courbe g(x).

On peut modéliser et simuler la réponse en fonction du temps t d'un amplificateur sans mémoire ANL à un signal d'entrée x sinusoïdal, de fréquence $f_0$, modulé en amplitude A et en phase $\phi$, signal ayant donc la forme suivante :

$$x(t) = A(t).\cos(2.f_0.t+\phi(t)) \tag{1}$$

A(t) représente l'enveloppe du signal d'entrée, qui est définie par les limites en amplitude dans lequel le signal sinusoïdal x évolue, l'enveloppe variant en fonction du temps. La figure 3 illustre un chronogramme d'un signal x(t) ayant une enveloppe A constante.

Le signal de sortie g de l'amplificateur sans mémoire est alors de la forme suivante :

$$g(t) = C(A(t)).\cos(2\pi.f_0.t+\phi(t)) \tag{2}$$

Il est intéressant de donner une enveloppe complexe à ces signaux x et g, en abandonnant toute référence au temps t puisque les amplificateurs sans mémoire ont une réponse instantanée.

Le signal d'entrée x de l'équation (1) a une enveloppe complexe X de la forme suivante :

$$X = A.\exp(j.\ \phi) \tag{3}$$

Toute l'information utile de modulation d'amplitude A(t) et de phase $\phi(t)$ est inscrite dans cette enveloppe complexe X.

Le signal de sortie g de l'équation (2) a de même une enveloppe complexe G de la forme suivante :

$$G = C(A).\exp(j.\phi) \tag{4}$$

Pour un amplificateur ANL non-linéaire sans mémoire, on démontre que C(A) est la transformée de Chebyshev de la courbe de réponse entrée/sortie g(x).

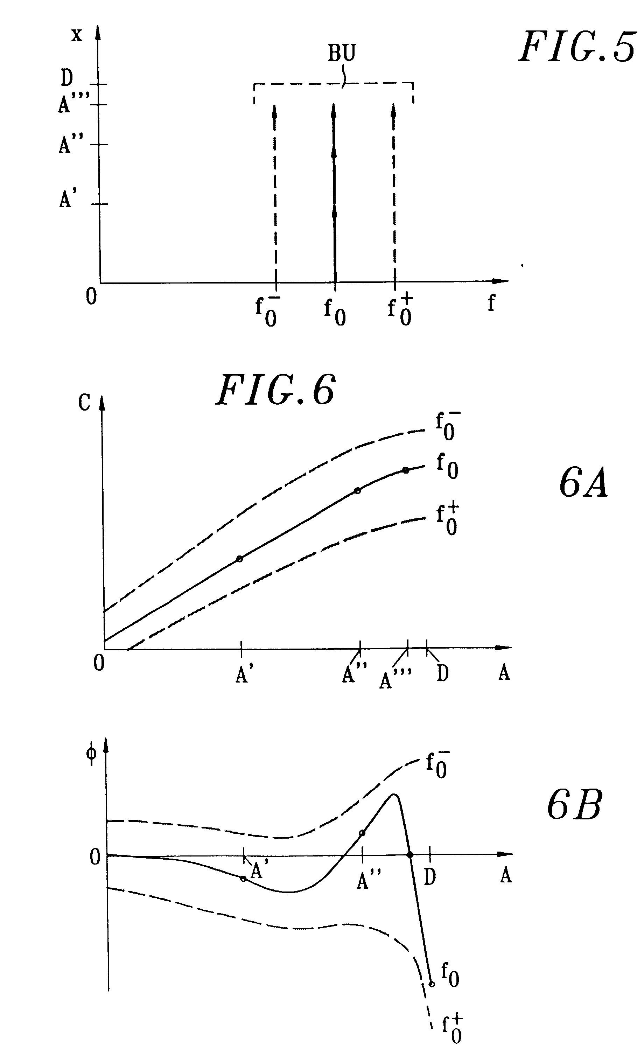

La réponse d'un amplificateur ANL non-linéaire sans mémoire à un signal x modulé peut donc être modélisée et simulée simplement par une seule courbe C(A), dont un exemple est illustré en trait plein sur la figure 6A. Une telle courbe donnant l'amplitude C de sortie en fonction de l'amplitude A d'entrée est appelée courbe de non-linéarité en amplitude et notée en abrégé courbe AM/AM.

La figure 2 illustre une caractéristique de réponse d'un amplificateur non-linéaire à mémoire ANLAM, sur laquelle apparaît un phénomène d'hystérésis provoqué par effet de mémorisation. On voit que les courbes de montée m et m' d'hystérésis ne se superposent pas lorsque les amplitudes A et A' respectives du signal d'entrée x sont différentes. La variation du temps de mémorisation liée à la variation d'amplitude empêche les courbes m et m' de se superposer.

Lorsque le temps de mémorisation de l'amplificateur ANLAM est négligeable par rapport à la période de variation d'amplitude A(t), on peut encore considérer que l'amplitude A est stable et on parle d'amplificateur quasi-sans-mémoire.

La figure 4 représente un chronogramme de signal de sortie y d'un amplificateur quasi-sans-mémoire auquel est appliqué le signal d'entrée x illustré sur le chronogramme de la figure 3 dont la formule est rappelée ci-après :

$$x(t) = A(t).\cos(2\pi.f_0.t + \phi(t)) \tag{1}$$

Pour un amplificateur non-linéaire quasi-sans-mémoire auquel on applique le signal x de l'équation (1), le signal de sortie y prend la forme suivante :

$$y(t) = C(A).\cos(2\pi.f_0.t - \Phi(A) + \phi(t)) \tag{5}$$

où

$C(A)$ est l'amplitude du signal de sortie y, et
$\Phi(A)$ est le déphasage du signal de sortie y,

qui dépendent de l'amplitude A(t) du signal d'entrée x.

Ainsi, à un instant t donné, l'amplitude $C(A)$ et le déphasage $\Phi(A)$ du signal de sortie y dépendent uniquement de l'amplitude A du signal d'entrée x à cet instant t. On peut donc négliger les variations d'amplitude A(t) en fonction du temps, et considérer quasiment que l'amplitude A est constante comme visible figure 3.

Il est également intéressant d'écrire sous forme complexe les enveloppes des signaux x et y exprimés précédemment, enveloppes X et Y qui prennent les formes respectives suivantes :

$$X = A.\exp(j.\phi) \tag{3}$$

(enveloppe A considérée comme constante dans le temps)

$$Y = C(A).\exp(j.\phi - \Phi(A)) \tag{6}$$

La réponse d'un amplificateur non-linéaire quasi-sans-mémoire peut donc être modélisée et simulée simplement en connaissant deux courbes caractéristiques suivantes :

- une courbe $C(A)$ donnant l'amplitude C du signal de sortie y en fonction de l'amplitude A du signal d'entrée, illustrée par exemple par la courbe AM/AM en trait plein de la figure 6A (courbe de conversion amplitude/amplitude).
- une courbe $\Phi(A)$ donnant le déphasage $\phi$ du signal de sortie y par rapport au signal d'entrée x, en fonction de l'amplitude A du signal x, dite courbe de conversion amplitude/phase, en abrégé AM/PM, dont un exemple est illustré en trait plein sur la figure 6B.

On démontre que la courbe $C(A)$ est, comme précédement, la norme de la transformée complexe de Chebychev de la caractéristique de réponse y(x), la courbe $\Phi(A)$ étant l'argument de la transformée complexe.

L'enveloppe complexe Y du signal de sortie peut également être écrite sous forme de deux parties, réelles et imaginaires, correspondant à une composante P en phase et à une composante Q en quadrature de phase, composantes P et Q de formes suivantes :

$$P(A) = C(A).\cos(\Phi(A)) \tag{7'}$$

$$Q(A) = C(A).\sin(\Phi(A)) \qquad\qquad (7")$$

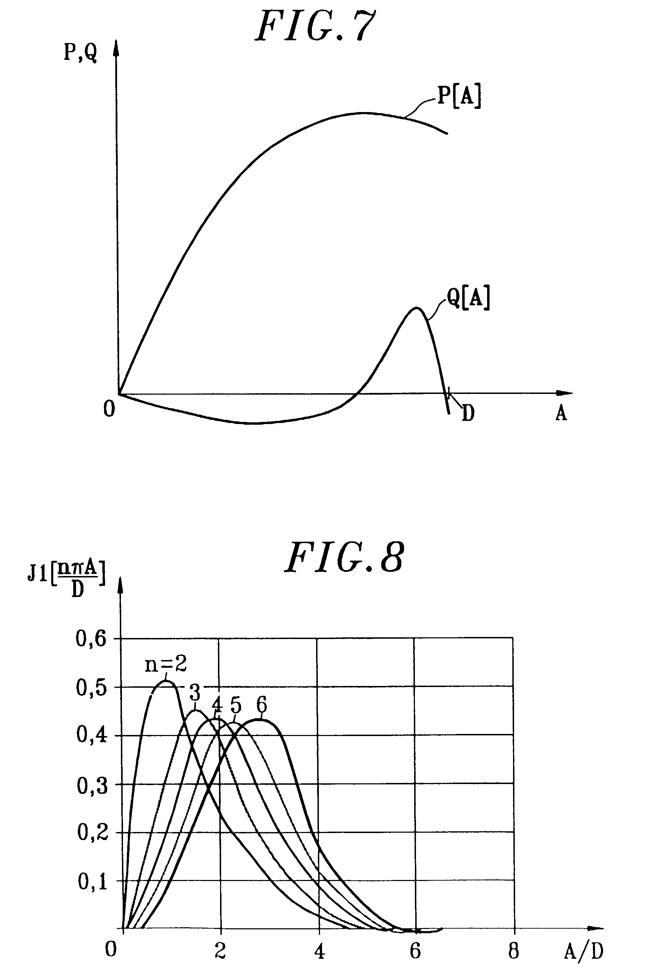

La figure 7 illustre un exemple de courbes P(A) et Q(A) équivalentes aux courbes C(A) et Φ(A) des figures 6A et 6B.

Les modèles connus de simulation de réponse d'amplificateur quasi-sans-mémoire préfèrent généralement utiliser des caractéristiques sous forme de paire de courbes P(A) et Q(A) plutôt que sous forme de paire de courbes C(A) et Φ(A), bien que ces paires de courbes soient strictement équivalentes.

Un principe connu de simulation d'amplificateur non-linéaire consiste à précaractériser sur un banc de test l'amplificateur réalisé, la précaractérisation étant effectuée avec un signal de fréquence et d'amplitude déterminées, afin de simuler ensuite la réponse à un signal de fréquence et d'amplitude quelconques.

Comme schématisé figure 5, un signal monofréquence $f_0$ prenant différentes amplitudes A', A'', A''' est appliqué à l'amplificateur testé pour obtenir ses caractéristiques, illustrées par exemple en figure 6 ou 7.

Cependant, pour des amplificateurs présentant une certaine quantité de mémoire, on constate que les caractéristiques varient de façon importante selon la fréquence $f_0^-$, $f_0$ ou $f_0^+$ du signal à amplifier.

Un système connu de simulation de tels amplificateurs a été exposé par H.B. Poza dans un article intitulé "A Wideband data link computer simulation model", publié dans les actes de conférence "NAECON'75 record", page 71. Il propose d'établir plusieurs paires de courbes AM/AM et AM/PM pour plusieurs fréquences $f_0^-$, $f_0$ ou $f_0^+$ de fonctionnement de l'amplificateur. Sur les figures 6A et 6B, on a ainsi représenté un exemple de trois paires de courbes AM/AM et AM/PM, obtenues respectivement à trois fréquences $f_0^-$, $f_0$ et $f_0^+$ situées dans la bande utile BU d'un amplificateur de liaison hertzienne.

Le simulateur de H.B. Poza stocke seulement une paire de courbes AM/AM et AM/PM, par exemple la paire de courbes obtenues à la fréquence $f_0$, et reconstitue les autres paires de courbes (non stockées) correspondant aux autres fréquences $f_0^-$, $f_0^+$ ou à des fréquences intermédiaires. Une courbe non stockée est déduite simplement en translatant la courbe stockée d'un vecteur adéquat. Le simulateur calcule les composantes selon l'axe (A) et selon l'axe (C) ou ($\phi$) du vecteur de translation pour rapprocher au mieux la courbe de fréquence $f_0$, représentée en trait plein à la figure 6A ou 6B, de la courbe de fréquence $f_0^-$ ou $f_0^+$, représentée en pointillés.

Un tel système de simulation est trop approximatif pour simuler les distorsions apparaissant sur un amplificateur quasi-sans-mémoire à différentes fréquences.

Un autre inconvénient d'un tel système est qu'il ne permet pas de simuler la réponse d'un amplificateur à mémoire.

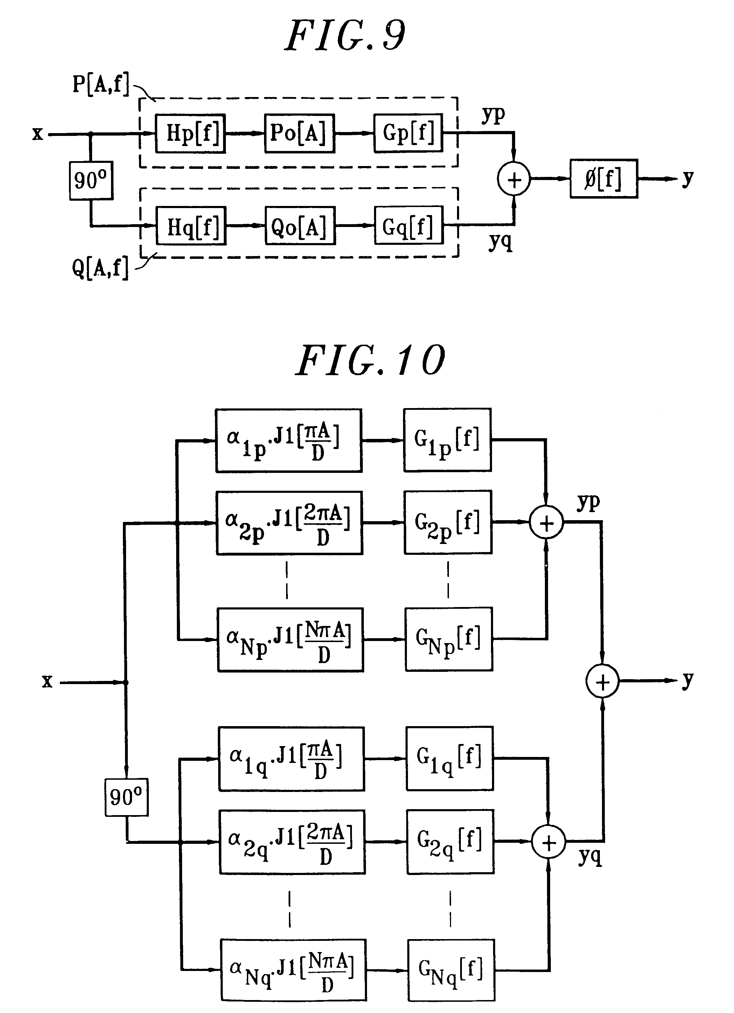

La figure 9 illustre un autre système connu de simulation, selon le modèle de A.A.M. Saleh, décrit dans un article intitulé "Frequency-independent and frequency-dependent models of TWTA Amplifiers" paru en novembre 1981 dans la revue "IEEE transactions on communication", volume com-29, n° 11, page 1715. Le calcul de la réponse à un signal d'entrée x d'un amplificateur non-linéaire quasi-sans-mémoire est décomposé en deux étapes P(A,f) et Q(A,f) de calcul de deux composantes yp et yq respectives du signal de sortie y. La composante yp est en phase avec le signal d'entrée x, tandis que la composante yq est en quadrature de phase.

Le système de simulation de Saleh utilise des résultats de caractérisation de l'amplificateur à plusieurs fréquences f, plusieurs paires de courbes P(A) et Q(A) étant établies à plusieurs fréquences f pour calculer des fonctions de transfert P(A,f) et Q(A,f) correspondant à chaque branche de calcul des composantes yp et yq du signal de sortie y. Chacune des fonctions de transfert P(A,f) ou Q(A,f) correspond au calcul d'une réponse non-linéaire sans effet de mémoire, aucun déphasage n'étant introduit dans chacune de ces branches de calcul.

L'article de A.A.M. Saleh signale que le modèle s'applique à l'amplification de signaux mono-fréquence et, par conjecture, suppose qu'il serait applicable à la simulation de signaux de forme quelconque.

Un autre inconvénient de ce modèle est qu'il ne s'applique pas aux amplificateurs à mémoire, le système ne rendant pas compte des distorsions apparaissant à différentes fréquences lorsque l'amplitude du signal varie rapidement par rapport aux constantes de temps de mémorisation.

Pour les amplificateurs non-linéaires à mémoire ANLAM, les effets de mémorisation sont plus importants, les temps de mémorisation n'étant pas négligeables par rapport aux temps de variation de l'amplitude A(t). Dans de tels cas, des méthodes plus complexes telles que la résolution d'équations différentielles non-linéaires ou le développement des caractéristiques en suites de fonctions sont nécessaires pour simuler la réponse de l'amplificateur à mémoire ANLAM.

Un modèle connu plus perfectionné est proposé par M.T. Abuelma'atti dans un article intitulé "Frequency-dependent nonlinear quadrature model for TWT amplifiers", paru en août 1984, dans la revue IEEE transaction on communication, volume com-32, N° 8, page 982. La modélisation utilise un développement des courbes caractéristiques d'un amplificateur non-linéaire en suite de fonctions de Bessel, ce qui permet de simuler la réponse d'amplificateurs à mémoire.

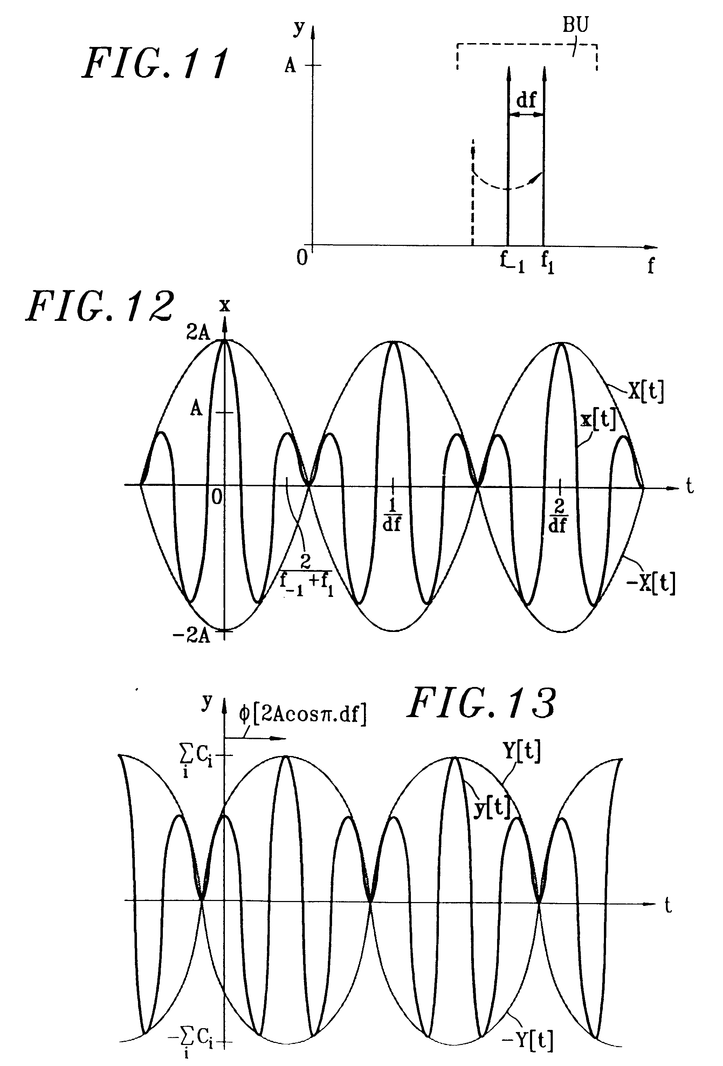

La figure 10 illustre le système de simulation décrit par M.T. Abuelma'atti qui comporte comme précédemment deux branches de calcul des composantes en phase yp et en quadrature yq du signal de sortie y, chaque branche calculant la contribution d'une suite de N fonctions de Bessel J1 dépendant de l'amplitude A du signal d'entrée x, en pondérant chaque fonction J1 d'un coefficient $\alpha$ et d'un facteur G(f) de correction en fréquence. Les coefficients $\alpha_n$ et les facteurs $G_n(f)$ sont calculés après avoir établi plusieurs paires de courbes P(A) et Q(A) caractéristiques de l'amplificateur non-linéaire, les courbes étant établies à plusieurs fréquences f de test de l'amplificateur.

Avec la figure 8, on peut voir qu'une double sommation pondérée de N fonctions de Bessel du premier type d'ordre 1, notées J1(n$\pi$A/D) permet d'interpoler très précisément une paire de courbes P(A) et Q(A), comme les deux courbes de la figure 7, en ajustant les coefficients $\alpha_{np}$ et $\alpha_{nq}$ de pondération de ces fonctions J1.

On peut noter que les fonctions de Bessel sont les transformées de Chebychev de fonctions sinusoïdales et que le développement en suite de fonctions de Bessel des courbes P(A) et Q(A) correspond à un développement de Fourier en suite de fonctions sinusoïdales des courbes y(x) de non-linéarité de l'amplificateur, ce qui convient élégamment à l'allure sinusoïdale des courbes d'hystérésis y(x), tel qu'illustrées figure 2.

Théoriquement, un tel système devrait permettre la simulation de l'amplification de signaux multi-porteuses, c'est-à-dire de signaux comportant plusieurs composantes sinusoïdales de fréquences distinctes.

Toutefois, l'amplification non-linéaire d'un signal d'entrée multi-porteuses est compliquée par l'apparition de distorsions appelées phénomènes d'intermodulation. Lorsqu'un amplificateur non-linéaire reçoit en entrée plusieurs fréquences porteuses, on obtient en sortie, en plus des porteuses amplifiées, des harmoniques non désirées appelées produits d'intermodulation, chaque harmonique ayant une fréquence distincte des fréquences des porteuses.

Les figures 11-14 illustrent l'apparition du phénomène d'intermodulation lors de l'amplification non-linéaire d'un signal à deux porteuses.

La figure 11 représente un diagramme fréquentiel de signal d'entrée x biporteuses, sur lequel on voit par exemple, deux composantes porteuses de fréquences respectives $f_{-1}$ et $f_1$ ayant une égale amplitude A d'entrée. Les deux fréquences porteuses $f_{-1}$ et $f_1$, situées dans la bande utile BU de fréquence de l'amplificateur, sont séparées par un écart fréquentiel df.

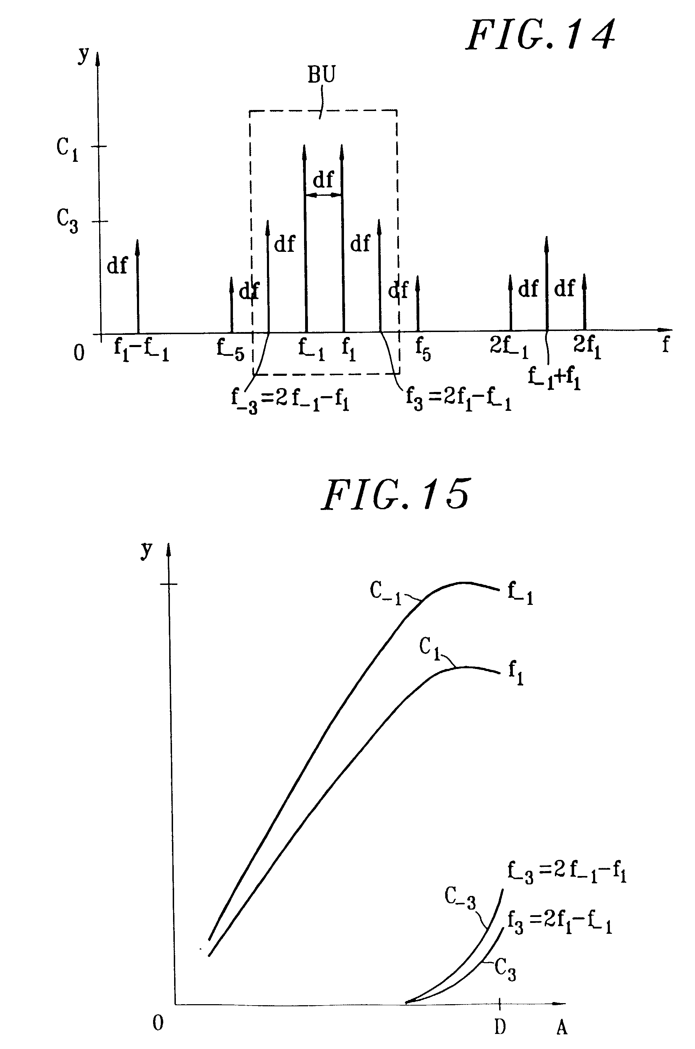

La figure 14 représente un diagramme fréquentiel de signal de sortie y qui correspond à l'amplification ANLAM avec effet de mémoire du signal d'entrée x biporteuse de la figure 11. On voit que le signal de sortie y comporte une série d'harmoniques de diverses fréquences f et d'amplitudes C différentes.

La fréquence de chacune des composantes d'intermodulation est une combinaison entière des fréquences porteuses en entrée.

Le détail des harmoniques de sortie comprises dans la bande utile BU, illustrées figure 14, est le suivant:

- les porteuses, de fréquence $f_{-1}$ et $f_1$, et d'amplitude de sortie respectives $C_{-1}$ et $C_1$.
- les composantes d'intermodulation d'ordre 3, de fréquences $f_{-3}$, $f_3$, et d'amplitudes de sortie respectives $C_{-3}$, $C_3$.

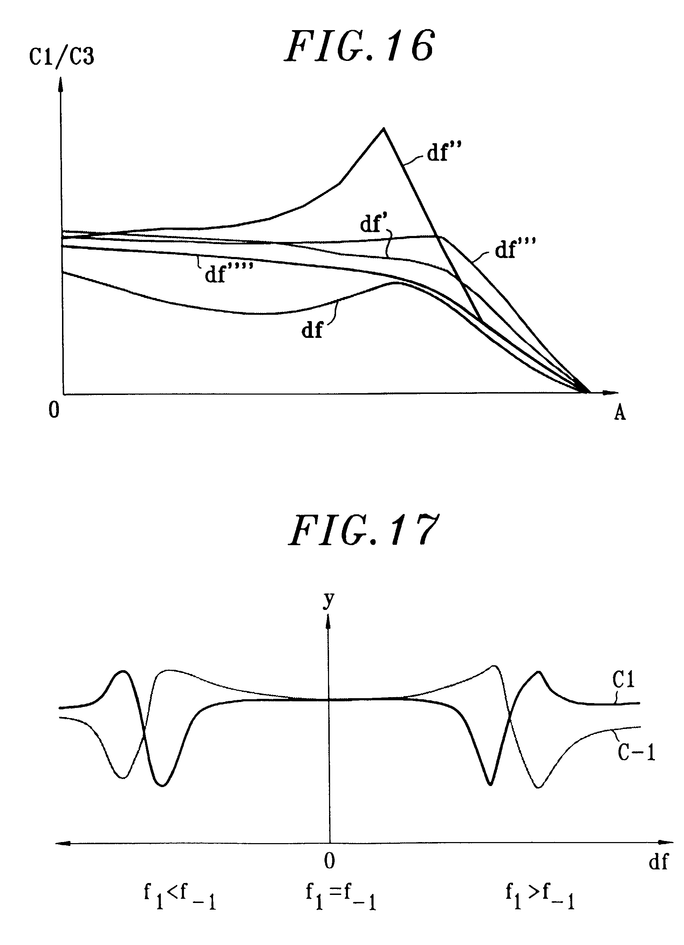

La figure 15 reproduit des résultats fournis par le modèle d'Abuelma'atti qui a permis une estimation des amplitudes $C_{-1}$, $C_1$, et $C_{-3}$, $C_3$ de sortie des composantes porteuses et des composantes d'intermodulation d'ordre 3.

Toutefois, l'estimation de l'amplitude des composantes d'intermodulation par le modèle d'Abuelma'atti correspond mal à la réalité des mesures de distorsions d'intermodulation lors de l'amplification de signaux multi-porteuses hyperfréquences par un amplificateur à mémoire en fonctionnement non-linéaire à haut rendement.

Il se produit en effet un phénomène général, appelé mémoire d'enveloppe lorsqu'on amplifie un signal multi-porteuses. Pour ce type de signal, l'enveloppe, définie par les limites positive et négative en amplitude du signal, n'est pas constante.

Dans ce cas, on ne peut plus considérer que l'enveloppe est constante comme dans les modèles quasi-sans mémoire. En fait, les constantes de temps de mémorisation ne sont plus négligeables vis-à-vis du temps de variation de l'enveloppe.

La figure 12 qui illustre l'évolution temporelle du signal d'entrée x biporteuses de la figure 11, montre par exemple que l'enveloppe X(t) et -X(t) du signal biporteuse varie très rapidement et dans des proportions importantes, alors que l'amplitude A de chaque porteuse $f_1$ et $f_{-1}$ porteuse est supposée constante.

La figure 13 qui illustre l'évolution temporelle du signal de sortie y correspondant au signal d'entrée x biporteuse précédent, montre ainsi que l'enveloppe Y(t) et -Y(t) du signal de sortie y, apparaît alors très déformée par les distorsions d'intermodulation. On désigne sous le nom d'effet de mémoire d'enveloppe de telles déformations d'amplitude du signal par un amplificateur non-linéaire à mémoire.

Les modèles connus ne rendent pas compte, en particulier, de deux effets illustrés aux figures 16 et 17.

Le premier effet observé est que le ratio C1/C3 illustré figure 16, comparant l'amplitude C1 de porteuses par rapport à l'amplitude C3 des composantes d'intermodulation, varie considérablement selon l'écart fréquentiel df des porteuses et selon la valeur précise de l'amplitude A des porteuses du signal d'entrée.

Si on appliquait le modèle d'Abuelma'atti, le ratio C1/C3 ne dépendrait pas de l'écart fréquentiel et varierait continûment selon l'amplitude A d'entrée

Le second effet observé est que la présence d'une seconde porteuse influence l'amplitude de sortie de la première porteuse.

La figure 17 montre par exemple des pics d'affaiblissement ou de résonnance d'amplitude C1 ou C-1 de sortie de chacune des porteuses de fréquence $f_1$ ou $f_{-1}$, selon l'écart fréquentiel df des deux porteuses (df valant $f_1$-$f_{-1}$).

Un inconvénient des modèles connus est de nepas rendre compte de ces effets.

De façon générale, l'inconvénient des modèles connus est qu'ils ne simulent pas d'effet de mémoire d'enveloppe.

L'objet de l'invention est de réaliser un système de simulation de réponse en signal d'un amplificateur non-linéaire présentant un effet de mémoire sans les inconvénients précités.

Un but premier de l'invention est d'obtenir des simulations précises des effets de mémoire d'enveloppe sur des amplificateurs non-linéaires.

Un but particulier de l'invention est d'obtenir des simulations précises de l'amplification de signaux multi-porteuses par un amplificateur non-linéaire à mémoire.

Un autre but de l'invention est de réaliser un système simple de simulation de réponse d'amplificateurs non-linéaires à mémoire.

Succintement, pour atteindre ces buts, l'invention prévoit une mesure dynamique des caractéristiques de l'amplificateur dans les conditions où apparaissent les distorsions, c'est-à-dire avec un signal modulé en amplitude, ce qui permet de faire varier l'enveloppe du signal.

Ainsi, il est prévu, selon l'invention, de mesurer des caractéristiques de distorsions de modulation d'amplitude, chaque mesure étant effectuée en modulant l'amplitude d'entrée. Ces mesures de caractéristiques de distorsions de modulation permettent de calculer des fonctions de transfert de modulation reproduisant en sortie les amplitudes des distorsions selon les amplitudes de modulation en entrée. Enfin, il est prévu que les amplitudes de distorsions reproduites par les fonctions de transfert de modulation corrigent la sortie de fonctions de transfert directes d'un modèle connu. Pour rappel, les modèles connus ont été obtenus en mesurant des caractéristiques de conversion amplitude/amplitude et de conversion amplitude/déphasage de l'amplificateur, chaque mesure étant effectuée à amplitude constante en entrée, puis en développant les caractéristiques en suite de fonction de transfert directes.

Les mesures de caractéristiques de distorsions de modulation sont effectués plus précisément avec des signaux multi-porteuses, c'est-à-dire en apliquant des signaux comportant plusieurs composantes fréquentielles (porteuses) en entrée de l'amplificateur non-linéaire, les signaux amplifiés en sortie présentant une multitude de composantes fréquentielles (porteuses amplifiées + produits d'intermodulation).

L'invention est réalisée en mettant en oeuvre un procédé de simulation de réponse en signal d'un amplificateur non-linéaire présentant un effet de mémoire, le procédé comportant des étapes consistant à :

- mesurer des caractéristiques de conversion amplitude/amplitude et de conversion amplitude/déphasage de l'amplificateur, chaque mesure étant effectuée à amplitude constante en entrée,
- développer les caractéristiques en suite de fonctions de transfert directes établissant l'amplitude et le déphasage de sortie selon l'amplitude d'entrée,
- mesurer des caractéristiques de distorsions de modulation de l'amplificateur en appliquant un signal comportant au moins deux composantes fréquentielles en entrée, les caractéristiques de distorsions de modulation étant mesurées pour plusieurs écarts fréquentiels et/ou plusieurs amplitudes des composantes fréquentielles, chaque mesure donnant l'amplitude de composantes fréquentielles de sortie en fonction de l'écart fréquentiel et de l'amplitude des composantes fréquentielles d'entrée, et
- calculer, d'après les mesures de caractéristiques de distorsions de modulation, une fonction de transfert de modulation corrigeant l'amplitude de composantes fréquentielles de sortie des fonctions de transfert directes lorsque l'amplitude d'entrée est modulée, selon les écarts fréquentiels et les amplitudes des composantes fréquentielles d'entrée, afin de simuler l'effet de mémoire d'enveloppe.

De préférence, le procédé selon l'invention comporte des étapes intercalaires consistant à :

- mesurer les caractéristiques à différentes fréquences, et
- calculer des correcteurs en fréquence pour les fonctions de transfert directes.

Une première réalisation du procédé selon l'invention prévoit de :

- mesurer des caractéristiques de réjection de composantes d'intermodulation apparaissant en sortie de l'amplificateur non-linéaire à des fréquences différentes des fréquences des composantes d'entrée, chaque mesure donnant l'amplitude de composantes d'intermodulation en fonction de l'écart fréquentiel et de l'amplitude des composantes fréquentielles d'entrée, et de

- calculer, d'après les mesures de caractéristiques de réjection de composantes d'intermodulation, une fonction de transfert de modulation établissant, selon les écarts fréquentiels et les amplitudes des composantes fréquentielles d'entrée, un signal modulateur modulant l'amplitude de composantes de sortie des fonctions de transfert directes, notamment l'amplitude des composantes fréquentielles d'intermodulation d'ordre trois.

De préférence si l'amplificateur est dissymétrique en fréquence, il est prévu de:

- mesurer deux facteurs de réjection de composantes d'intermodulation pour chaque écart fréquentiel et chaque amplitude des composantes fréquentielles d'entrée,
- calculer une fonction de transfert de modulation dissymétrique ayant une réponse à un écart fréquentiel négatif distincte de la réponse à un écart fréquentiel positif.

Une deuxième réalisation du procédé selon l'invention prévoit de :

- mesurer des caractéristiques d'interaction de composantes fréquentielles en appliquant un signal comportant au moins deux composantes fréquentielles en entrée de l'amplificateur non-linéaire, chaque mesure donnant l'amplitude de sortie desdites composantes fréquentielles en fonction de l'écart fréquentiel et de l'amplitude d'entrée desdites composantes fréquentielles, et de
- calculer, d'après les mesures de caractéristiques d'interaction de composantes fréquentielles, une fonction de transfert de correction établissant, selon les écarts fréquentiels et les amplitudes des composantes fréquentielles d'entrée, un signal de correction ajustant l'amplitude ou l'amplitude modulée de composantes fréquentielles issues des fonctions de transfert directes.

De préférence, comme l'amplificateur a une variation de gain de porteuses en fonction de la fréquence d'enveloppe, il est prévu de mesurer des caractéristiques de gain en amplitude pour une porteuse en présence d'une autre porteuse en fonction de l'écart féquentiel des porteuses.
Une troisième réalisation du procédé selon l'invention prévoit de :

- mesurer des caractéristiques de bruit de modulation en sortie, chaque mesure étant effectuée avec des amplitudes déterminées de modulation en entrée. En particulier, il est prévu de:
- mesurer des caractéristiques de report (NPR) de bruit dans une fenêtre (BH) de fréquence, chaque mesure étant effectuée avec un bruit blanc (DSP) à fenêtre (BH) en entrée.

L'invention est réalisée en outre avec un dispositif de simulation de réponse en signal d'un amplificateur non-linéaire présentant un effet de mémoire, le dispositif comportant :

- un module de calcul de la réponse d'un amplificateur non-linéaire à un signal monoporteuse, le module comportant :

  - au moins un filtre direct ayant une fonction de transfert établie à partir de caractéristiques de conversion amplitude/amplitude et de conversion amplitude/déphasage, mesurées réellement sur l'amplificateur, chaque fonction de transfert directe étant établie avec un signal monoporteuse prenant différentes amplitudes,

- des moyens de génération d'harmoniques en réponse à un signal multi-porteuses, et
- au moins un filtre de modulation de la réponse du module de calcul, le filtre de modulation ayant une fonction de transfert établie à partir de caractéristiques de distorsions de modulation d'amplitude mesurées réellement sur l'amplificateur, chaque fonction de transfert de modulation étant établie avec des signaux multi-porteuses.
  De préférence, le module du dispositif selon l'invention comporte en outre :
- au moins un correcteur en fréquence pondérant la fonction de transfert d'un filtre direct, chaque correcteur ayant une fonction de correction établie à partir de caractéristiques de conversion mesurées sur l'amplificateur à différentes fréquences de signal monoporteuse.

Les moyens de génération d'harmoniques du dispositif comportent de préférence selon l'invention un module de décomposition de Fourier d'un signal en composantes fréquentielles et/ou un module combinatoire calculant les combinaisons de fréquence de composantes d'intermodulation et/ou un module normatif calculant une valeur efficace d'amplitude de signal.
Un premier mode de réalisation de dispositif selon l'invention prévoit que le filtre de modulation a une fonction de transfert établie à partir de caractéristiques de réjection de composantes d'intermodulation, de sorte que des composantes d'intermodulation d'amplitude calculée par le filtre de modulation sont ajoutées à la réponse du module de calcul lorsque l'amplification d'un signal multi-porteuses est simulée par le dispositif.

Un deuxième mode de réalisation de dispositif selon l'invention prévoit en outre un filtre de correction de la réponse du module de calcul, le filtre ayant une fonction de transfert établie à partir de caractéristiques d'interaction de porteuses, de sorte que l'amplitude d'une porteuse fournie par le module de calcul est corrigée par le filtre de correction lorsque l'amplification d'un signal multi-porteuses est simulée par le dispositif.

L'invention s'applique de façon avantageuse à la simulation de réponse en signal d'un amplificateur hyperfréquence fonctionnant à haut rendement.

D'autres caractéristiques, buts et avantages de la présente invention apparaîtront à la lecture de la description détaillée qui va suivre, et des dessins annexés, donnés à titre d'exemples non limitatifs.

Sur les dessins annexés :

- les figures 1 et 2, précédemment décrites, illustrent des courbes de réponse d'amplificateurs non-linéaires ;
- les figures 3 et 4, précédemment décrites, illustrent des diagrammes temporels de réponse en signal d'amplificateur non-linéaire sans mémoire ou quasi-sans-mémoire ;
- la figure 5, précédemment décrite, schématise un diagramme fréquentiel de mesures de caractéristiques selon un principe connu ;
- les figures 6A et 6B, précédemment décrites, illustrent des caractéristiques d'amplificateur non-linéaire sous forme de courbes de conversion amplitude/amplitude et de courbes de conversion amplitude/déphasage, obtenues selon un procédé connu ;
- la figure 7, précédemment décrite, illustre des caractéristiques d'amplificateur non-linéaire, sous forme de courbes de non-linéarité en phase et en quadrature, obtenues selon un procédé équivalent connu;
- la figure 8, précédemment décrite, illustre une suite de fonction de Bessel de décomposition des caractéristiques mises en oeuvre dans un procédé de simulation connu ;
- les figures 9 et 10, précédemment décrites, représentent deux dispositifs de simulation connus ;
- les figures 11 et 14, précédemment décrites, illustrent des diagrammes fréquentiels d'amplitude de signaux multi-porteuses, respectivement en entrée et en sortie d'un amplificateur non-linéaire à mémoire ;
- les figures 12 et 13, précédemment décrites, illustrent des diagrammes temporels d'amplitude de signaux multi-porteuses, respectivement en entrée et en sortie d'un amplificateur non-linéaire à mémoire ;
- la figure 15, précédemment décrite, reproduit des résultats de simulation d'amplitudes de composantes fréquentielles de sortie d'un amplificateur non-linéaire selon l'amplitude des porteuses d'un signal d'entrée bi-porteuses, simulation effectuée selon un modèle connu ;
- la figure 16 illustre des mesures de réjection de composante d'intermodulation en sortie par rapport aux composantes porteuses en entrée d'un amplificateur non-linéaire à mémoire exprimé sous forme de ratio C1/C3 d'amplitude de sortie de porteuse/amplitude de composante d'intermodulation, en fonction de l'amplitude A en entrée des porteuses, pour divers écarts fréquentiels df des porteuses, mesures mises en oeuvre selon l'invention ;
- la figure 17 illustre des mesures d'interaction de porteuses en sortie d'un amplificateur non-linéaire à mémoire, sous forme d'amplitude de sortie y d'une porteuse en fonction de l'écart fréquentiel des porteuses, mesures mises en oeuvre selon l'invention ;

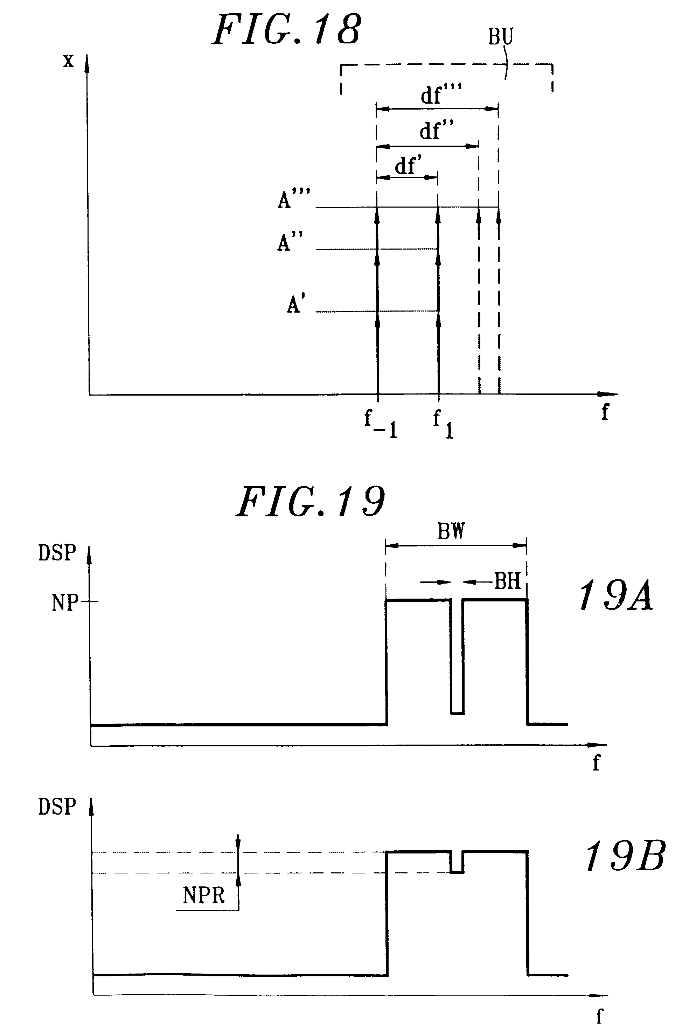

- la figure 18 représente un diagramme fréquentiel de mesures de caractéristiques mis en oeuvre selon l'invention ;
- Les figures 19A et 19B représentent des exemples de densité spectrale de puissance (DSP) du signal utilisé en entrée de l'amplificateur pour la mesure du NPR ;

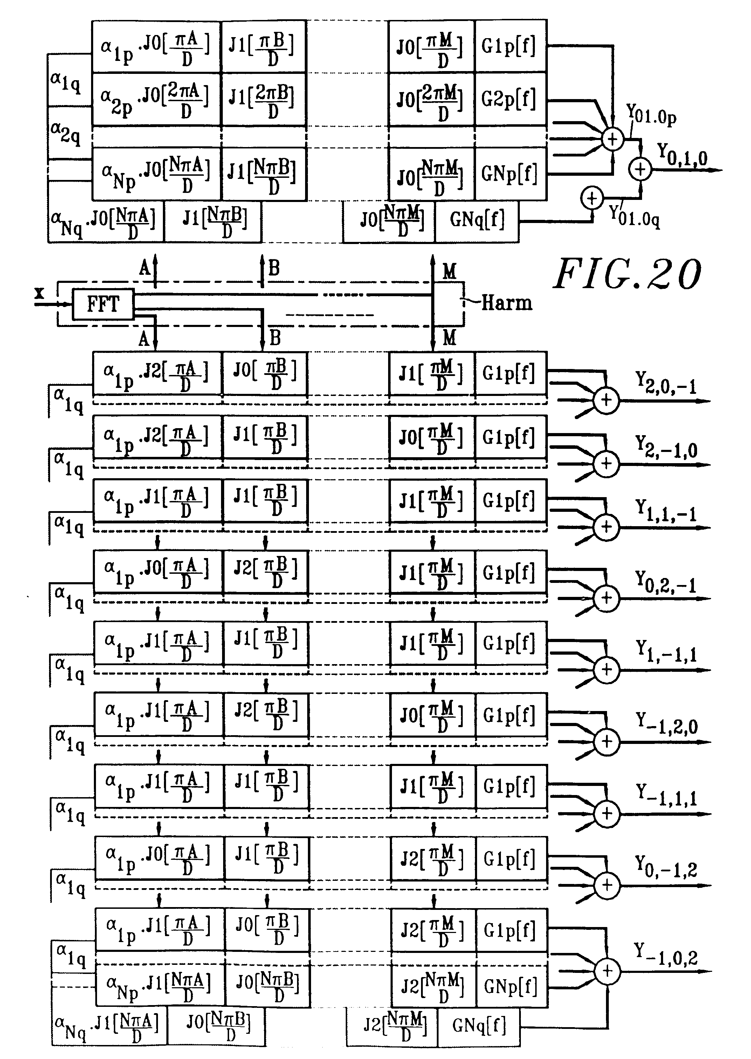

- la figure 20 représente une réalisation de dispositif de simulation d'amplification non-linéaire à mémoire comportant des moyens de génération d'harmoniques selon l'invention ;

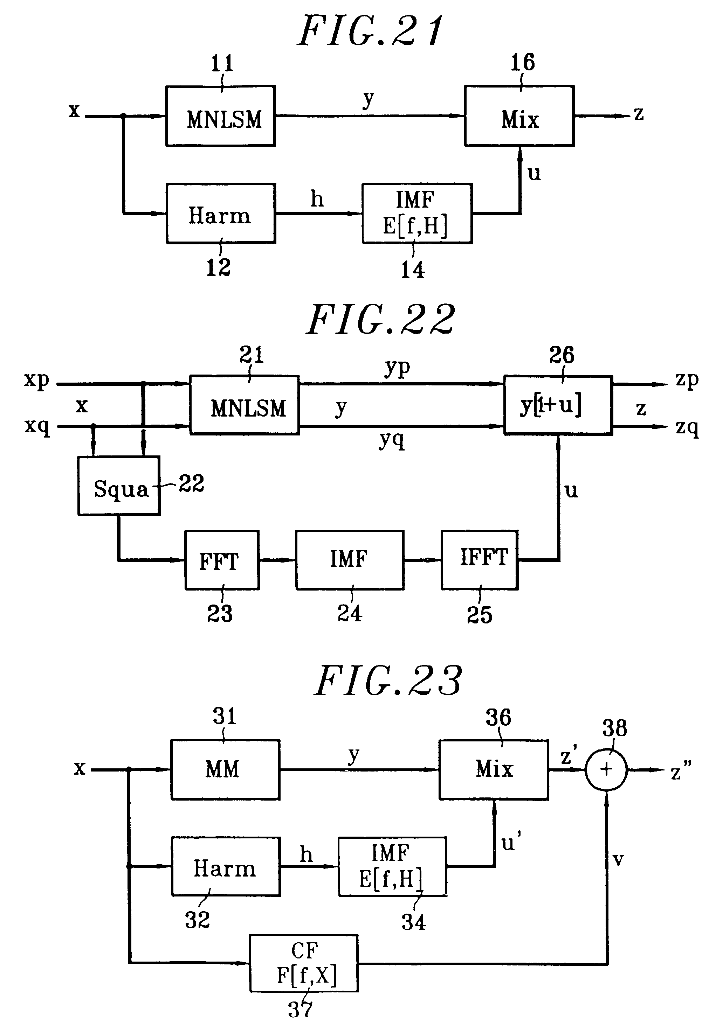

- la figure 21 représente un premier mode de réalisation de dispositif de simulation d'amplification non-linéaire à mémoire selon l'invention ;
- la figure 22 représente une variante du premier mode de réalisation de dispositif de simulation d'amplification non-linéaire à mémoire selon l'invention;
- la figure 23 représente un deuxième mode de réalisation de dispositif de simulation d'amplification non-linéaire à mémoire selon l'invention ;

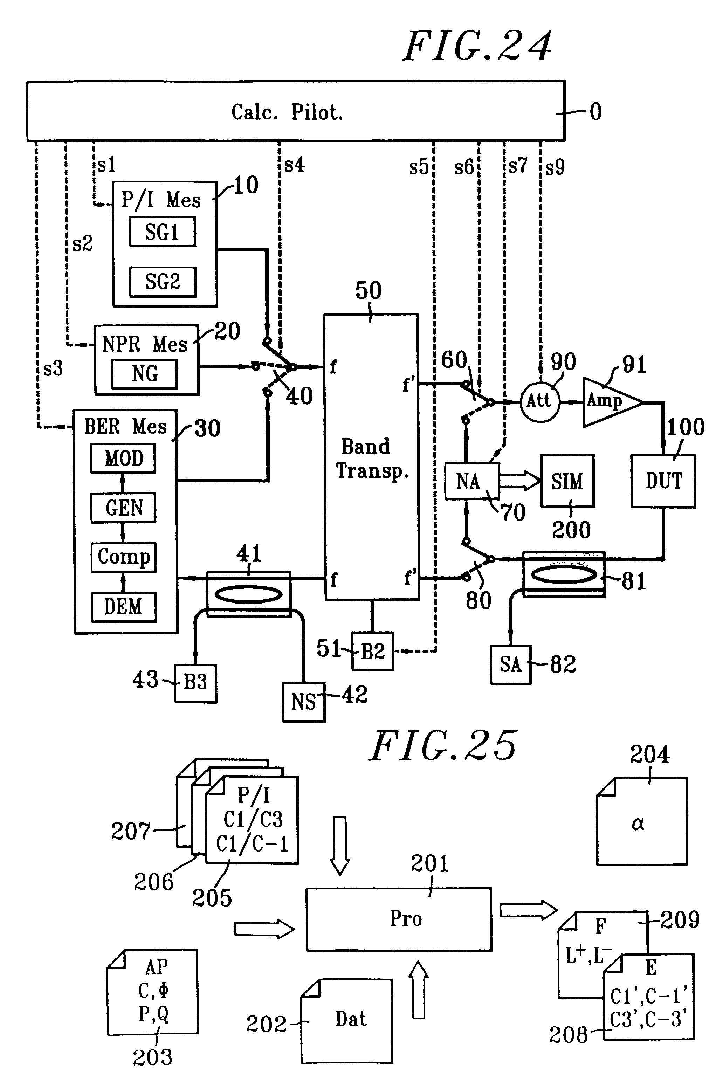

- la figure 24 représente un banc de mesure de caractéristiques de distorsions d'intermodulation utilisé par le procédé ou le dispositif selon l'invention ;
- la figure 25 représente un diagramme de fichiers de caractéristiques mis en oeuvre par un processus de simulation de réponse d'un amplificateur non-linéaire selon l'invention ; et,

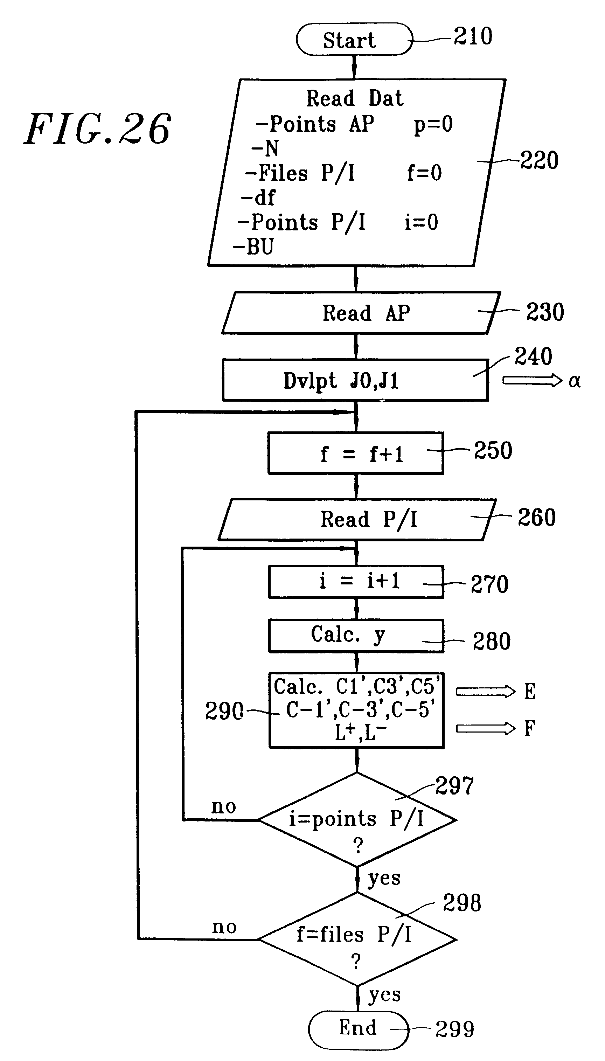

- la figure 26 représente un schéma d'étapes de processus de simulation de réponse d'un amplificateur non-linéaire selon l'invention.

Les procédé et dispositif de simulation selon l'invention sont développés à partir des modélisations connues.

L'invention se propose de simuler l'amplification de signaux de forme quelconque et notamment de signaux comportant plusieurs composantes fréquentielles.

Selon une première caractéristique de dispositif selon l'invention, le dispositif de simulation comporte des moyens de génération d'harmoniques en réponse à un signal multi-porteuses.

Ainsi les diverses structures, illustrées aux figures 21 à 23, de dispositif selon l'invention, comportent systématiquement un bloc 11 ou 21 ou 31 de calcul de signal de sortie y selon un modèle connu et un bloc parallèle 12 ou 22, 23 ou 32 de génération d'harmoniques qui calcule les fréquences des composantes d'intermodulation avant le calcul de leur amplitude précise pour corriger le signal de sortie y. Les blocs de calcul de signal de sortie 11, 21 et 31 sont prévus pour mettre en oeuvre un modèle de simulation connu, par exemple et respectivement le modèle non-linéaire sans mémoire MNLSM de H.B. Poza, le modèle non-linéaire sans mémoire MNLSM quadratique de A.A.M. Saleh et le modèle à mémoire MM de M.T. Abuelma'atti. D'autres modèles peuvent être mis en oeuvre, et la description de la mise en oeuvre de l'invention sera développée essentiellement à partir du modèle perfectionné de M.T. Abuelma'atti.

On notera que la structure en parallèle des blocs de calcul de sortie MNLSM ou MM et des blocs Harm de génération d'harmoniques est indicative, la structure des blocs pouvant être en série, et la réalisation effective des blocs de calculs étant de préférence effectuée par des programmes d'ordinateur, les blocs schématisant dans ce cas les fonctions de sous-programmes de calcul.

La figure 23 décrit le détail d'une réalisation alternative de moyens Harm de génération d'harmoniques et de moyens MM de calcul des composantes d'intermodulation perfectionnée à partir du modèle d'Abuelma'atti simple illustré figure 10. Les modules Harm et MM permettent d'effectuer le calcul des amplitudes de composantes d'inter-modulation..., $Y_{010}$, $Y_{1-11}$, $Y_{-120}$, $Y_{-111}$, $Y_{0-12}$, $Y_{-102}$, $Y_{20-1}$, $Y_{2-10}$, $Y_{11-1}$, $Y_{02-1}$, ... lorsque le signal d'entrée x comporte une multitude de composantes fréquentielles A, B, ..., M. Cette réalisation complexe de moyens Harm et MM est destinée à la simulation de l'amplification de signaux de forme quelconque, en particulier de signaux multi-porteuses.

On note sur la figure 20 que les moyens Harm de génération d'harmoniques comportent un filtre FFT de décomposition en série de Fourier pour décomposer le signal d'entrée x multifréquence en composantes fréquentielles d'amplitude A, B, ..., M. Ces composantes sont appliquées en entrée de filtres élémentaires groupés par tableaux correspondant au calcul d'une composante d'intermodulation, par exemple $Y_{010}$. Chaque filtre élémentaire a une fonction de transfert issue d'une fonction de Bessel J généralisée sur l'exemple des filtres de la figure 10. Les formules des fonctions de transfert des filtres du tableau et des fonctions de Bessel généralisées seront détaillées dans les développements ci-après.

On retiendra que l'architecture d'un dispositif selon l'invention comporte des moyens de génération d'harmoniques avec de préférence un module de décomposition en série de Fourier et un modèle de simulation connu.

Un développement des formules proposées par le modèle connu le plus perfectionné, le modèle d'Abuelma'atti aboutit à des erreurs de simulation, comme démontré ci-après, erreurs qui seront corrigées selon l'invention.

En effet, suivant les équations précédentes 7' et 7", Abuelma'atti décompose isolément les caractéristiques de non-linéarité en phase P et en quadrature Q, en suite de N fonctions de Bessel, selon les formules suivantes :

$$P = \sum_{n=1}^{N} \alpha_{np} \cdot J1\,(n.\pi.A/D) \qquad (8')$$

$$Q = \sum_{n=1}^{N} \alpha_{nq} \cdot J1\,(n.\pi.A/D) \qquad (8'')$$

où

2D est la dynamique en entrée de l'amplificateur, et
$\alpha_{np}$, $\alpha_{nq}$ sont des coefficients calculés par une méthode de minimisation de l'erreur quadratique présentée dans l'article cité.

Cette décomposition et le dispositif de simulation d'Abuelma'atti correspondant sont illustrés figure 10.

Supposons maintenant que le signal d'entrée x comporte deux porteuses de fréquence $f_{-1}$ et $f_1$ et d'amplitudes égales notée A, c'est-à-dire que le signal x a la forme suivante :

$$x(t) = A.\cos(2\pi.f_{-1}.t) + A.\cos(2\pi.f_1.t) \tag{9}$$

Le signal d'entrée x a alors une enveloppe X fortement modulée en amplitude, comme indiqué par la figure 12 et la formule suivante :

$$X(t) = 2A\cos(\pi.df.t) \tag{10}$$

où

df = $f_1$-$f_{-1}$ représente l'écart fréquentiel des deux porteuses $f_{-1}$ et $f_1$.

D'après les modèles quadratiques quasi-sans-mémoire, l'enveloppe Y du signal de sortie correspondant au signal d'entrée x des équations 9 et 10, prendrait la forme quadratique suivante :

$$Y_p(t) = C[2A.\cos(\pi.df.t)].\cos(\Phi[2A.\cos(\pi.df.t)]) \tag{11'}$$

$$Y_q(t) = C[2A.\cos(\pi.df.t)].\sin(\Phi[2A.\cos(\pi.df.t)]) \tag{11''}$$

où

$Y_p$ serait la composante en phase de l'enveloppe Y du signal de sortie y, et
$Y_q$ serait la composante en quadrature de l'enveloppe Y.

Or les formules 11 et 11' ne peuvent pas être appliquées directement pour la simulation d'amplificateurs ANLAM non-linéaires à mémoire car l'enveloppe d'entrée X est sinusoïdale de fréquence moitié de l'écart df et varie trop rapidement dans le temps par rapport aux constantes de temps de mémorisation.

D'après le modèle plus perfectionné d'Abuelma'atti, l'enveloppe Y du signal de sortie correspondant au signal d'entrée x biporteuse des équations 9 et 10 comporte une série de composantes de fréquence notée $f_i$ et d'amplitude notée $C_i$, i étant un entier positif ou négatif.

Dans le détail, comme illustré figure 14, les composantes fréquentielles du signal de sortie y ont les fréquences et les amplitudes suivantes :

- une composante porteuse, de fréquence $f_1$ d'amplitude de sortie $C_1$ ;
- une composante porteuse, de fréquence $f_{-1}$ d'amplitude de sortie $C_{-1}$ ;
- des composantes d'intermodulation d'ordre 2, de fréquences valant respectivement $2.f_{-1}$, $f_{-1}+f_1$, $2.f_1$ ainsi que $f_{-1}-f_1$, d'amplitudes non référencées,
- une composante d'intermodulation d'ordre 3, de fréquence notée $f_3$ valant $2.f_1-f_{-1}$ et d'amplitude $C_3$,
- une composante d'intermodulation d'ordre 3, de fréquence notée $f_{-3}$ valant $2.f_{-1}-f_1$ et d'amplitude $C_{-3}$,
- une composante d'intermodulation d'ordre 5, de fréquence notée $f_5$ valant $3.f_1-2.f_{-1}$ et d'amplitude $C_5$,
- une composante d'intermodulation d'ordre 5, notée $f_{-5}$ valant $3.f_{-1}-2.f_1$ et d'amplitude $C_{-5}$, et
- d'autres composantes d'ordre impair d'importance moindre et d'autres composantes d'ordre pair généralement rejetées hors de la bande utile BU.

Seules les composantes d'intermodulation d'ordre 3 et éventuellement d'ordre 5, sont situées dans la bande utile BU et ont des amplitudes $C_{-3}$, $C_3$, $C_{-5}$, $C_5$ suffisantes pour être étudiés dans la réponse de l'amplificateur.

On notera que l'ordre des composantes d'intermodulation est la somme des valeurs absolues des coefficients entiers de combinaison des fréquences porteuses.

Le signal de sortie y correspondant est la somme des amplitudes des composantes fréquentielles selon la formule suivante :

$$y(t) = \sum_i 2.C_i(A).\cos(2\pi.f_i.t) \tag{12}$$

où

i prend toutes les valeurs entières impaires négatives et positives, et $C_i$ est une amplitude complexe qui se décompose en partie réelle $C_{ip}$ (en phase) et en partie imaginaire $C_{iq}$ (en quadrature), selon l'écriture suivante :

$$C_i(A) = C_{ip}(A) + C_{iq}(A) \tag{13}$$

Abuelma'atti a montré, dans l'article précité, que le calcul des amplitudes $C_i$ des composantes d'intermodulation issues de l'amplification d'un signal biporteuse pouvait être effectué à partir d'une sommation de fonctions de Bessel Jn du premier type mais d'ordres n divers, selon les formules suivantes :

$$C_{1p}(A) = \sum_{n=1}^{N} \alpha_{np}.J0(n.\pi.A/D).J1(n.\pi.A/D).G_{np}(f_1) \tag{14'}$$

$$C_{1q}(A) = \sum_{n=1}^{N} \alpha_{nq}.J0(n.\pi.A/D).J1(n.\pi.A/D).G_{nq}(f_1) \tag{14''}$$

$$C_{-1p}(A) = \sum_{n=1}^{N} \alpha_{np}.J1(n.\pi.A/D).J0(n.\pi.A/D).G_{np}(f_{-1}) \tag{15'}$$

$$C_{-1q}(A) = \sum_{n=1}^{N} \alpha_{nq}.J1(n.\pi.A/D).J0(n.\pi.A/D).G_{nq}(f_{-1}) \tag{15''}$$

$$C_{3p}(A) = \sum_{n=1}^{N} \alpha_{np}.J1(n.\pi.A/D).J2(n.\pi.A/D).G_{np}(f_3) \tag{16'}$$

$$C_{3q}(A) = \sum_{n=1}^{N} \alpha_{nq}.J1(n.\pi.A/D).J2(n.\pi.A/D).G_{nq}(f_3) \tag{16''}$$

$$C_{-3p}(A) = \sum_{n=1}^{N} \alpha_{np}.J2(n.\pi.A/D).J1(n.\pi.A/D).G_{np}(f_{-3}) \tag{17'}$$

$$C_{-3q}(A) = \sum_{n=1}^{N} \alpha_{nq} \cdot J2(n.\pi.A/D).J1(n.\pi.A/D).G_{nq}(f_{-3}) \qquad (17'')$$

où

$\alpha_{np}$, $\alpha_{nq}$ sont les coefficients obtenus aux équations 8' et 8", en développant les caractéristiques P et Q de non-linéarité en fonctions de Bessel J1 d'ordre 1 uniquement, et

J0, J1, J2 sont des fonctions de Bessel du premier type d'ordre 0, 1, 2, respectivement.

L'ordre 0, 1, 2 ou N d'une fonction de Bessel J0, J1, J2 ou JN est choisi de façon à correspondre à la valeur absolue du coefficient entier de combinaison d'une fréquence porteuse $f_{-1}$ ou $f_1$ dans la fréquence $f_i$ de la composante d'intermodulation d'amplitude $C_i$. L'ordre IiI de chaque composante d'intermodulation $C_i$ correspond donc à la somme des ordres 0, 1, 2 ou N des fonctions de Bessel J0, J1, J2 ou JN impliquées dans chaque formule.

Dans le cas général où le signal d'entrée x comporte m composantes fréquentielles (porteuses), d'amplitudes quelconques, notées A, B, ..., M, on obtient une multitude de produits d'intermodulation ayant chacun une fréquence donnée par la formule suivante :

$$f_i = \alpha.f_A + \beta.f_B + ... + \mu.f_M$$

où

$\alpha$, $\beta$, ..., $\mu$ sont des entiers relatifs, et

$f_A$, $f_B$, ..., $f_M$ sont les fréquences des porteuses A, B, ..., M respectivement présentes dans le signal d'entrée x.

L'amplitude $C_i$ de chaque composante d'intermodulation de fréquence $f_i$ suit la formulation générale suivante :

$$C_{ip}(A,B,...,M) = \sum_{n=1}^{N} \alpha_{np}.J|\alpha|(n.\pi.A/D).J|\beta|(n.\pi.B/D).J|\mu|(n.\pi.M/D)$$

$$C_{iq}(A,B,...,M) = \sum_{n=1}^{N} \alpha_{nq}.J|\alpha|(n.\pi.A/D).J|\beta|(n.\pi.B/D).J|\mu|(n.\pi.M/D)$$

où

JInI est la fonction de Bessel du premier type et d'ordre valeur absolue de n (généralisation).

La figure 20 illustre ainsi une réalisation sophistiquée de moyens de calcul MM de composantes d'intermodulation développée à partir de ces formules de modèle à mémoire.

On a représenté schématiquement sous forme de tableau de filtres élémentaires connectés en série horizontalement pour calculer le produit des fonctions de Bessel $J|\alpha|$ généralisées, modulées par l'amplitude des composantes A, B, ..., M du signal multi-porteuse. Chaque résultat horizontal est ensuite additionné avec les autres résultats horizontaux du tableau et avec les résultats d'un tableau similaire pour les composantes en quadratures avant de fournir en sortie l'amplitude d'une harmonique $Y\alpha,\beta,...,\mu$.

Sur cet exemple de réalisation sophistiqué, on voit que à partir d'une porteuse centrale B et de deux porteuses latérales A et M on obtient, outre la porteuse amplifiée $Y_{010}$ de fréquence $f_B$, au moins neuf produits d'intermodulation $Y_{20-1}$, $Y_{2-10}$, $Y_{11-1}$, $Y_{02-1}$, $Y_{1-11}$, $Y_{-120}$, $Y_{-111}$, $Y_{0-12}$ et $Y_{-102}$ aux environs immédiats de la fréquence centrale $f_B$.

On voit donc que le nombre de produits d'intermodulation croît exponentiellement avec le nombre m de porteuses, et que la réalisation d'une simulation pour un signal à plus de deux porteuses ne peut être détaillée dans la présente, l'homme de métier pouvant la concevoir en généralisant les calculs décrits pour deux porteuses.

Un facteur de qualité déterminant dans la conception et le choix d'un système d'amplification hyperfréquence est le rapport de l'amplitude $C_3$ de la plus forte composante d'intermodulation en sortie et de l'amplitude $C_1$ en sortie d'une composante porteuse.

Dans la présente ce facteur, appelé facteur de réjection d'intermodulation, est exprimé par la formule suivante :

$$P/I = C1/C3 \tag{18}$$

Plus le ratio P/I est élevé, plus la qualité du système est élevée, la porteuse C1 se distinguant mieux du bruit d'intermodulation représenté par C3.

Dans le domaine hyperfréquence, le facteur de réjection est généralement exprimé en puissance, ce qui correspond au ratio suivant :

$$C1^2/C3^2 \text{ noté ici } P/I^2.$$

Sous forme quadratique le facteur de réjection d'intermodulation s'écrit sous la forme suivante :

$$P/I^2 = \frac{(C_{1p}^2 + C_{1q}^2)}{(C_{3p}^2 + C_{3q}^2)} \tag{19}$$

En utilisant les résultats précédents des équations 14', 14" et 16', 16" établies par Abuelma'atti, on s'aperçoit que le facteur de réjection d'intermodulation simulé pour un amplificateur hyperfréquence varie très peu selon la fréquence.

En effet les correcteurs en fréquence $G_n(f_i)$ ont un faible effet de correction, la courbe des correcteurs $G_n$ étant calculée à partir de mesures avec une seule porteuse, donc sans modulation de l'enveloppe d'entrée. En particulier, les facteurs de réjection d'intermodulation P/I ainsi calculés ne sont pas fonction de l'écart fréquentiel df des porteuses, contrairement aux effets de résonnance constatés et illustrés par exemple sur la figure 16.

Selon un premier mode de réalisation de l'invention, il est prévu précisément de mesurer des caractéristiques de réjection d'intermodulation et d'utiliser ces mesures pour corriger le signal y de sortie calculé à partir d'un modèle connu.

Dans le développement qui va suivre, le signal y(t) calculé selon le modèle d'Abuelma'atti est comparé à un signal z(t) comportant des composantes d'intermodulation telles que réellement mesurées. Une telle comparaison fournit la valeur d'un signal u(t) de modulation qui sera simulée par un filtre de modulation selon l'invention.

La figure 21 schématise un premier mode de réalisation de dispositif selon l'invention, qui comporte un tel filtre 14 de modulation. Le filtre 14 a une fonction de transfert E(f, H) qui calcule le signal u en fonction du signal d'entrée. Le signal y du modèle connu 11 est alors corrigé par le signal modulateur u pour fournir un signal z qui reproduit les distorsions de modulation effectivement mesurées.

Le développement suivant permet d'établir un exemple de relations permettant de construire la fonction de transfert E(f, H) du filtre IMF de calcul des intermodulations.

On constate d'abord que le signal modulateur u est utile seulement si le signal d'entrée a une enveloppe X modulée en amplitude. En effet, lorsque le signal d'entrée x n'est pas modulé, le modèle connu 11 a un signal de sortie y qui simule convenablement la réponse de l'amplificateur.

L'invention prévoit précisément d'obtenir l'enveloppe du signal en prenant le carré de la norme du signal x. En considérant l'équation 10 donnant l'enveloppe X du signal biporteuse d'amplitude A et d'écart fréquentiel df, on obtient ainsi le carré $X^2$ de l'enveloppe suivant:

$$X^2(t) = 4.A^2.\cos^2(\pi.df.t) \tag{20}$$

Le carré $X^2$ donné par l'équation 20 se décompose en une amplitude $A^2$ constante et un facteur de modulation donnés par l'équation suivante :

$$X^2(t) = 2.A^2. + 2.A^2.\cos(2\pi.df.t) \tag{20'}$$

La figure 21 montre ainsi que le filtre 14 reçoit en entrée la valeur efficace $X^2(t)$ de l'enveloppe du signal d'entrée x.

Selon l'invention, on considère que le signal modulateur u issu du filtre 14 doit permettre d'écrire une formule de correction suivante :

$$Z(t) = Y(t).[1+U(t)] \qquad (21)$$

où

Z est l'enveloppe du signal z de sortie avec les intermodulations telque mesuré,
Y est l'enveloppe du signal y calculé par un modèle connu, et
U est l'enveloppe du signal u.

De la sorte, en l'absence de modulation en entrée, le signal z simulé selon l'invention a une enveloppe Z qui correspond à l'enveloppe Y du signal de sortie y simulé par le modèle connu MNLSM ou MM, et le signal modulateur u est avantageusement nul.

Par hypothèse, on exprime l'enveloppe U du signal modulateur, de façon analogue à l'équation 20', comme le résultat de la transformation de la valeur efficace $X^2$ par la fonction de transfert $E(f,H)$ qui dépend de la fréquence f et de l'amplitude H des harmoniques h en entrée, c'est-à-dire sous la forme suivante :

$$U(t) = 2A^2.E(0,A) + 2A^2.E(df,A).\cos(2\pi.df.t) \qquad (22)$$

où

$E(df,A)$ est la réponse de la fonction de transfert à un signal de fréquence df (fréquence correspondant à l'écart fréquentiel des porteuses) et d'amplitude A,
$E(0,A)$ est la réponse de la fonction de transfert à écart fréquentiel nul.

Conventionnellement, $E(0,A)$ a une valeur nulle, puisqu'il est inutile d'avoir un signal modulateur u quand il n'y a pas d'écart de fréquence de porteuses.

On note K l'inconnue suivante :

$$K = A^2.E(df,A)$$

Il est préférable d'écrire l'enveloppe U du signal modulateur donné par l'équation 22, sous la forme complexe et exponentielle suivante :

$$1+U(t) = K.\exp(-j.2\pi.df.t) + 1 + K.\exp(j.2\pi.df.t) \qquad (23)$$

De façon équivalente à l'équation (12), on préfère ici écrire l'enveloppe Y du signal de sortie y du modèle connu sous la forme complexe et exponentielle suivante :

$$Y(t) = \sum_i C_i(A).\exp(j.i.\pi.df.t) \qquad (24)$$

où i est un entier impair prenant toutes les valeurs négatives et positives. Soit :

$$Y(t) = ... + C_{-5}.\exp(-j.5\pi.df.t) + C_{-3}.\exp(-j.3\pi.df.t)$$

$$+ C_{-1}.\exp(-j.\pi.df.t) + C_1.\exp(j.\pi.df.t)$$

$$+ C_3.\exp(j.3\pi.df.t) + C_5.\exp(j.5\pi.df.t) +... \qquad (24')$$

On déduit donc des équations (21), (23) et (24'), le développement suivant :

$$Z(t) = ... + (K.C_{-5}+C_{-3}+K.C_{-1}).\exp(-j.3\pi.df.t)$$

$$+ (K.C_{-3}+C_{-1}+K.C_1).\exp(-j.\ \pi.df.t)$$

$$+ (K.C_{-1}+C_1+K.C_3).\exp(j.\ \pi.df.t)$$

$$+ (K.\ C_1+C_3+K.C_5).\exp(j.3\pi.df.t) + ... \qquad (25)$$

Dans le premier mode de réalisation on cherche à moduler uniquement l'amplitude des composantes d'intermodulation d'ordre 3 en modifiant au minimum l'amplitude des composantes porteuses (ordre 1) calculée par le modèle connu. Ceci s'obtient en minimisant la valeur de K, de sorte que les termes $K.C_{-3}$, $K.C_1$, $K.C_{-1}$ et $K.C_3$ soient négligea-bles. Dans ce cas, les deux lignes centrales de l'équation (25) indiquent que les composantes porteuses de fréquence $f_{-1}$ et $f_1$ ont bien une amplitude sensiblement égale à $C_{-1}$ et $C_1$, respectivement, dans le signal de sortie z modulé.

Dans un premier temps, on peut considérer que les amplitudes $C_i$ de composantes d'intermodulation ne dépendent pas de la fréquence $f_i$, en supprimant les corrections en fréquence $G_{np,q}(f_i)$ prévues dans les formules de calcul 12' à 15". Le calcul est alors simplifié, car les composantes symétriques en fréquence $f_{-i}$ et $f_i$ autour des porteuses $f_{-1}$ et $f_1$ ont des amplitudes égales, selon l'identité suivante :

$$C_{-i} = C_i$$

Les deux dernières lignes de l'équation (23) représentent les composantes de fréquence $f_1$ et $f_3$ respective-ment, ce qui permet de calculer le facteur de réjection P/I qui a finalement la valeur suivante :

$$P/I = \frac{\left| C_1 + K.\ (C_1+C_3) \right|}{\left| C_3 + K.\ (C_1+C_5) \right|} \qquad (26)$$

Numériquement, après avoir déterminé les amplitudes $C_1(A)$, $C_3(A)$ et $C_5(A)$ des composantes selon les méthodes connues, et après avoir mesuré la valeur du facteur de réjection P/I pour cette valeur d'amplitude A des porteuses, on résoud l'équation (26) pour déterminer la valeur de l'inconnue K.

Pour la résolution, on écrit de préférence l'inconnue K sous la forme complexe suivante :

$$K = |K|.\exp(j.\theta)$$

On fait varier l'argument $\theta$ pour calculer les valeurs de la norme $|K|$ en fonction des valeurs de l'argument $\theta$.

La minimisation recherchée précédemment de la modification d'amplitude $C_{-1}$ et $C_1$ des porteuses $f_{-1}$ et $f_1$ est obtenue en retenant l'argument $\theta$ permettant d'obtenir la valeur minimale de la norme $|K|$.

La figure 18 permet de schématiser la systématique de mesures effectuées selon l'invention. On voit que les caractéristiques sont déterminées en effectuant une série de mesures avec un signal multi-porteuses $f_{-1}$ et $f_1$, en faisant varier à la fois l'amplitude A, A', A" des porteuses mais aussi l'écart fréquentiel df' = $f_1$-$f_{-1}$ des porteuses. En outre, on peut faire varier la fréquence de base f de la porteuse $f_1$ ou $f_{-1}$ servant de référence à l'écart fréquentiel df

Pour chaque écart fréquentiel df, comme illustré sur la figure 16, on peut mesurer une courbe P/I caractéristique en fonction de l'amplitude A ou de la puissance de porteuse en entrée. En appliquant le calcul précédent, on obtient alors pour chaque écart fréquentiel df une courbe des valeurs d'inconnue K en fonction de l'amplitude A des porteuses. En faisant varier les écarts fréquentiels df, df', df", df''', df"" des porteuses, on obtient ainsi un tableau de courbes de valeurs d'inconnues K. Ce tableau de valeurs K établit la trame de la fonction de transfert E(df,H) du filtre 14.

La continuité de la fonction de transfert E(df,H) selon l'amplitude H des harmoniques h en entrée ou selon la puissance $X^2$ de l'enveloppe du signal d'entrée x est obtenue en interpolant les valeurs discrètes du tableau des valeurs d'inconnues K.

Les calculs et interpolations sont effectuées également pour toutes les valeurs d'écart fréquentiel df, les valeurs d'inconnue K pouvant également être interpolées entre les valeurs choisies df', df", df''', df"" d'écart fréquentiel df.

Un programme informatique exécute de préférence de tels calculs et stocke les valeurs d'inconnue K sous forme de matrice.

Dans un second temps, on considère que les amplitudes $C_i$ des composantes d'intermodulation dépendent de la fréquence $f_i$ selon les formules complètes des équations 14' à 17". Il n'y a plus alors d'identité entre $C_i$ et $C_{-i}$.

Les dissymétries en fréquence de la réponse de l'amplificateur peuvent alors être simulées par cette variante du premier mode de réalisation.

Dans ce cas, l'invention prévoit que la fonction de transfert E'(df,H) du filtre 14 peut être dissymétrique.

Les hypothèses de l'équation 22 et du calcul précédent sont alors modifiés selon la formule complexe suivante :

$$U'(t) = A^2.E'(-df,A).exp(-j.2\pi.df.t)$$

$$+2A^2.E'(O,A)+$$

$$A^2.E'(df,A).exp(j.2\pi.df.t) \qquad (27)$$

où

E'(O,A) a une valeur nulle car le filtre ne transfère pas de composante continue de signal, et
E'(-df,A) est la réponse de la fonction de transfert E' à un écart fréquentiel -df, réponse distincte de la réponse E'(df,A) à un écart fréquentiel df, en raison de la dissymétrie du filtre E'.

Notons les termes de l'équation 22', sous la forme simplifiée suivante :

$$K^+ = A^2.E'(df,A)$$

et

$$K^- = A^2.E'(-df,A)$$

L'équation 23 est alors modifiée selon la formule suivante :

$$1+U'(t) = K^-.exp(-j.2\pi.df.t)+1 + K^+.exp(j.2\pi.df.t) \qquad (28)$$

Notons $C_i'$ les composantes modulées du signal de sortie z' modulé obtenu selon cette variante du premier mode de réalisation. Le signal de sortie z' est encore obtenu en modulant le signal y d'un modèle connu par un signal modulateur u' calculé par la fonction de transfert E' du filtre 34 de la figure 23. Ceci permet de distinguer les composantes $C_i'$ modulées selon l'invention, des composantes $C_i$ calculées par le modèle sans mémoire MNLSM connu.

Selon les équations 21, 24' et 28 précédentes, les composantes modulées ont des amplitudes $C_{-3}'$, $C_{-1}'$, $C_1'$, $C_3'$ déterminées par les formules suivantes :

$$C_1' = K^+.C_{-1} + C_1 + K^-.C_3 \qquad (29)$$

$$C_3' = K^+.C_1 + C_3 + K^-.C_5 \qquad (30)$$

$$C_{-1}' = K^+.C_{-3} + C_{-1} + K^-.C_1 \qquad (31)$$

$$C_{-3}' = K^+.C_{-5} + C_{-3} + K^-.C_{-1} \qquad (32)$$

On obtient alors deux résultats plus complexes de facteurs de réjection d'intermodulation, notés P/I+ et P/I-, selon que le facteur de réjection est mesuré sur les fréquences $f_1$ et $f_3$ supérieures ou sur les fréquence $f_{-1}$ et $f_{-3}$ inférieures de porteuse et d'intermodulation. Les deux facteurs de réjection ont les formes suivantes

$$P/I^+ = |C_1'/C_3'| = \frac{\left|K^+.C_{-1} + C_1 + K^-.C_3\right|}{\left|K^+.C_1 + C_3 + K^-.C_5\right|} \qquad (33)$$

$$P/I^- = |C_{-1}'/C_{-3}'| = \frac{\left|K^+.C_{-3} + C_{-1} + K^-.C_1\right|}{\left|K^+.C_{-5} + C_{-3} + K^-.C_{-1}\right|} \qquad (34)$$

On résoud ensuite, de façon connue, le système des deux équations 33 et 34 à deux inconnues K- et K+.

Ainsi quand l'amplificateur a une réponse dissymétrique autour des fréquences porteuses, il est prévu selon l'invention de mesurer des caractéristiques de réjection d'intermodulation, en prévoyant de mesurer les deux facteurs de réjection P/I+ supérieur et P/I- inférieur pour chaque amplitude A et écart fréquentiel df de porteuses, afin de simuler les distorsions de modulation en sortie.

Un second mode de réalisation de l'invention permet de simuler le second effet de distorsion d'intermodulation.

Le second effet observé est la variation du gain des porteuses en fonction de la fréquence d'enveloppe df/2, illustré par exemple sur la figure 17. En mesurant le gain de l'amplificateur pour une porteuse $f_1$ d'amplitude $C_1$ de sortie, en présence d'une autre porteuse $f_{-1}$, on se rend compte que le gain peut avoir des variations importantes, en fonction de l'écart fréquentiel df des deux porteuses $f_{-1}$ et $f_1$.

L'invention prévoit d'ajuster les amplitudes $C_1$ et $C_{-1}$ de sortie des porteuses calculée par un modèle connu, en tenant compte de mesures de caractéristiques C1/C-1 d'interaction de porteuses.

De préférence, l'ajustement du second mode de réalisation se combine à l'ajustement des principales composantes d'intermodulation $C_3$ et $C_{-3}$ prévu dans le premier mode de réalisation de l'invention, précédemment exposé. On peut prévoir en outre un ajustement des composantes $C_5$ et $C_5$ d'intermodulation secondaires.

Dans le second mode de réalisation de dispositif selon l'invention, l'ajustement est effectué en corrigeant le signal de sortie y, ou de préférence le signal modulé z ou z', par un signal de correction v issu d'un filtre 37 ayant une fonction de transfert F de correction.

La fonction de transfert F est calculée, de façon analogue à la fonction E, en supposant une correction des composantes modulées $C_i'$ formulées précédemment aux équations 29 à 32 selon les formules suivantes :

$$C_3'' = K^+.C_1 + C_3 + K^-.C_5 \qquad (35)$$

$$C_{-3}'' = K^+.C_{-5} + C_{-3} + K^-.C_{-1} \qquad (36)$$

$$C_1'' = K^+.C_{-1} + C_1 + K^-.C_3 + L^+ \qquad (37)$$

$$C_{-1}'' = K^+.C_{-3} + C_{-1} + K^-.C_1 + L^- \qquad (38)$$

dans lesquelles,

$$L^+ = A.F(df,A)$$

$$L^- = A.F(df,A)$$

où

F est la fonction de transfert de correction exprimée en fonction de la fréquence de modulation de l'enveloppe, c'est-à-dire de l'écart fréquentiel df des porteuses d'amplitude A en entrée.

Les composantes $C_3''$, $C_{-3}''$, $C_1''$ et $C_{-1}''$ sont appelées composantes corrigées.

Les équations 35 à 38 forment un système de quatre équations à quatre inconnues $K^+$, $K^-$, $L^+$, $L^-$ qui est résolu de façon connue. La résolution des deux dernières équations 37 et 38 fournit les valeurs des inconnues de correction $L^+$ et $L^-$.

La mesure précise des amplitudes réelles des composantes $f_3$, $f_{-3}$ d'intermodulation d'ordre 3 et des porteuses $f_1$, $f_{-1}$ permet ainsi, après calcul des composantes $C_{-5}$, $C_{-3}$, $C_{-1}$, $C_1$, $C_3$, $C_5$ d'ordre 1, 3 et 5 selon un modèle connu, de calculer les fonctions de transfert de modulation E(df,A) et de correction F(df,A).

De telles mesures complètes d'amplitudes de composantes en sortie d'un amplificateur comportant à la fois des mesures de réjection de composante d'intermodulation d'ordre 3 et 5 en sortie et des mesures d'interaction de porteuses permettent ainsi de simuler complètement la réponse en signal avec les distorsions dues à l'effet de mémoire d'enveloppe d'un amplificateur non-linéaire à mémoire. On notera cependant que des mesures partielles comme les mesures de réjection C1/C3 d'intermodulation d'ordre 3 ou les mesures d'interaction de porteuses C1/C-1 suffisent à caractériser certains effets de distorsion d'intermodulation.

Un deuxième mode de réalisation permet la validation du modèle par la mesure du rapport signal à bruit en présence d'un nombre élevé de porteuses dont la densité spectrale de puissance DSP est modélisée par un bruit blanc.

Les figures 19A et 19B illustrent ainsi un diagramme fréquentiel de bruit, respectivement appliqué en entrée et mesuré en sortie d'un amplificateur non-linéaire à mémoire pour le caractériser.

Selon l'invention, comme illustré sur la figure 19A, on applique un bruit blanc ayant une densité spectrale de puissance DSP de niveau NP constant dans une bande de fréquence BW sauf dans une fenêtre BH de fréquence dans laquelle le bruit est absent. Ce signal d'entrée bien qu'ayant une densité spectrale constante est d'amplitude variable. Il permet donc de mesurer les distorsions de modulation apparaissant en sortie de l'amplificateur. Les distorsions apparaissent en sortie de l'amplificateur sous forme de report de bruit dans la fenêtre BH précédemment définie.

La caractérisation de l'amplificateur consiste à mesurer sa capacité à limiter le report de bruit dans la fenêtre BH en mesurant la différence de niveau de bruit NPR en sortie, dans la bande de fréquence BW et dans la fenêtre BH.

Ces mesures de caractéristiques sont effectuées à différents niveaux NP de bruit et sont introduites dans le simulateur afin qu'il reproduise ces caractéristiques de bruit selon les conditions de fonctionnement.

Un troisième mode de contrôle de la validité du modèle consiste à mesurer le taux d'erreur binaire lors d'une amplification de porteuses modulées.

La figure 24 illustre un banc de test utilisé pour établir selon l'invention des mesures de caractéristiques d'amplificateur DUT non-linéaire à mémoire. Ce banc de test, dont la compréhension du fonctionnement est à la portée de l'homme de métier, comporte notamment un bloc 10 de génération de signal modulé en amplitude avec, par exemple, deux générateurs SG1 et SG2 de fréquences pouvant être distinctes pour appliquer un signal multi-porteuses au dispositif DUT amplificateur à caractériser. Il comporte en outre un bloc 20 de mesure de bruit avec un générateur NG de bruit blanc à fenêtre et éventuellement un bloc 30 de mesure de taux d'erreur binaire avec un générateur MOD de signaux modulés par un message binaire aléatoire et un comparateur Comp du signal d'origine et du signal de retour de l'amplificateur.

La figure 25 illustre enfin un diagramme des fichiers de caractéristiques mis en oeuvre par un programme informatique pour simuler l'amplification non-linéaire selon le procédé de l'invention.

Le programme Pro fait ainsi appel à un fichier 203 stockant des résultats de mesures de caractéristiques AP statiques, c'est-à-dire de courbes C,Φ ou de courbes P,Q établies à amplitude constante (de façon connue).

Le programme Pro fait encore appel à une série de fichiers 205, 206, 207 stockant des résultats de mesures de caractéristiques P/I dynamiques comme des courbes C1/C3 de réjection d'intermodulation ou des courbes C1/C-1 d'interaction de porteuses. Chaque fichier 205 ou 206 ou 207 de la série est établi par exemple pour un écart fréquentiel df de porteuses.

Le programme est lancé après avoir introduit des données générales Dat sur l'amplificateur à simuler.

En sortie, le programme Pro fournit un fichier 204 des coefficients $\alpha$ de suite de fonctions de transfert directes, notamment de fonctions de Bessel. Il fournit surtout selon l'invention des fichiers 208, 209 contenant les données des fonctions de transfert de modulation E et de correction F précitées.

La figure 26 représente un exemple de schéma d'étape de processus mis en oeuvre par un tel programme Pro.

La réalisation de dispositif selon l'invention est effectuée de préférence sous forme de programme informatique dont les fonctions correspondent aux blocs schématisés à titre d'exemple sur les figures 20 à 24.

D'autres applications variantes de réalisation et améliorations pourront être mises en oeuvre par l'homme de métier sans sortir du cadre de la présente invention, dont la portée est définie par les revendications ci-après.

**Revendications**

1. Procédé de simulation de réponse en signal d'un amplificateur non-linéaire présentant un effet de mémoire, le procédé comportant des étapes consistant à :

   - mesurer des caractéristiques (C, Φ, P, Q) de conversion amplitude/amplitude (C[A]) et de conversion amplitude/déphasage (Φ[A]) de l'amplificateur, chaque mesure étant effectuée à amplitude (A) constante en entrée, et
   - développer les caractéristiques (P, Q) en suite de fonctions (J1) de transfert directes établissant l'amplitude et le déphasage de sortie (y) selon l'amplitude d'entrée (x),

   le procédé étant caractérisé par des étapes consistant à :

   - mesurer des caractéristiques (C1/C3, C1/C-1) de distorsions de modulation de l'amplificateur en appliquant un signal comportant au moins deux composantes fréquentielles (f1, f-1) en entrée, les caractéristiques de distorsions de modulation étant mesurées pour plusieurs écarts fréquentiels (df', df'', df''') et/ou plusieurs amplitudes (A', A'', A''') des composantes fréquentielles (f1, f-1), chaque mesure donnant l'amplitude (C3, C1, C-1, C-3) de composantes fréquentielles de sortie (f3, f1, f-1, f-3) en fonction de l'écart fréquentiel (df) et de l'amplitude (A) des composantes fréquentielles d'entrée (f1, f-1), et
   - calculer, d'après les mesures de caractéristiques de distorsions de modulation, une fonction de transfert de modulation (E[f,H], F([f,X]) corrigeant l'amplitude de composantes fréquentielles de sortie (y) des fonctions de transfert directes (MM, MNLSM) lorsque l'amplitude d'entrée (x) est modulée, selon les écarts fréquentiels (f) et les amplitudes (H, X) des composantes fréquentielles d'entrée (h, x), afin de simuler l'effet de mémoire d'enveloppe.

2. Procédé selon la revendication 1, caractérisé par des étapes intercalaires consistant à :

   - mesurer les caractéristiques à différentes fréquences ($f_0$-, $f_0$, $f_0$+), et
   - calculer des correcteurs (G[f]) en fréquence pour les fonctions de transfert directes.

3. Procédé selon la revendication 1 ou 2, caractérisé par des étape consistant à :

   - mesurer des caractéristiques (C1/C3) de réjection de composantes d'intermodulation (f3, f-3) apparaissant en sortie de l'amplificateur non-linéaire à des fréquences différentes des fréquences (f1, f-1) des composantes d'entrée, chaque mesure donnant l'amplitude (C3, C-3) de composantes d'intermodulation (f3, f-3) en fonction de l'écart fréquentiel (df) et de l'amplitude (A) des composantes fréquentielles d'entrée (f1, f-1), et
   - calculer, d'après les mesures de caractéristiques de réjection de composantes d'intermodulation, une fonction de transfert de modulation (E[f,H]) établissant, selon les écarts fréquentiels (f) et les amplitudes (H) des composantes fréquentielles d'entrée, un signal modulateur (u) modulant (Mix, y[1+u]) l'amplitude de composantes de sortie (y) des fonctions de transfert directes, notamment l'amplitude (C3, C-3) des composantes fréquentielles d'intermodulation d'ordre trois (f3, f-3).

4. Procédé selon la revendication 3, caractérisé en ce que, l'amplificateur étant dissymétrique en fréquence, il est prévu de :

   - mesurer deux facteurs de réjection (C1/C3, C-1/C-3) de composantes d'intermodulation (f3, f-3) pour chaque écart fréquentiel (df) et chaque amplitude (A) des composantes fréquentielles d'entrée, et de
   - calculer une fonction de transfert de modulation (E'[f,H]) dissymétrique ayant une réponse à un écart fréquentiel négatif (-df) distincte de la réponse à un écart fréquentiel positif (df).

5. Procédé selon l'une des revendications 1 à 4, caractérisé par des étapes consistant à :

   - mesurer des caractéristiques (C1/C-1) d'interaction de composantes fréquentielles (f1, f-1) en appliquant un signal comportant au moins deux composantes fréquentielles (f1, f-1) en entrée de l'amplificateur non-linéaire, chaque mesure donnant l'amplitude de sortie (C1, C-1) desdites composantes fréquentielles en fonction de l'écart fréquentiel (df) et de l'amplitude d'entrée (A) desdites composantes fréquentielles, et
   - calculer, d'après les mesures de caractéristiques d'interaction de composantes fréquentielles, une fonction de transfert de correction (F[f,X]) établissant, selon les écarts fréquentiels (df) et les amplitudes (A) des composantes fréquentielles d'entrée, un signal de correction (v) ajustant l'amplitude (C1, C-1) ou l'amplitude modulée (C1', C-1') de composantes fréquentielles (f1, f-1) issues des fonctions de transfert directes.

6. Procédé selon la revendication 5, caractérisé en ce que l'amplificateur ayant une variation de gain de porteuses (f-1, f1) en fonction de la fréquence d'enveloppe (df/2), il est prévu de mesurer des caractéristiques de gain en amplitude (C1) pour une porteuse (f1) en présence d'une autre porteuse (f-1) en fonction de l'écart féquentiel (df) des porteuses (f-1, f1).

7. Procédé selon l'une des revendications 1 à 6, caractérisé par une étape consistant à :

   - mesurer des caractéristiques de bruit (DSP) de modulation en sortie, chaque mesure étant effectuée avec des amplitudes (A) déterminées de modulation en entrée.

8. Procédé selon l'une des revendications 1 à 7, caractérisé par une étape consistant à :

   - mesurer des caractéristiques de report (NPR) de bruit dans une fenêtre (BH) de fréquence, chaque mesure étant effectuée avec un bruit blanc (DSP) à fenêtre (BH) en entrée.

9. Procédé selon l'une des revendications 1 à 8, caractérisé en ce qu'il est appliqué à la simulation de réponse en signal d'un amplificateur hyperfréquence fonctionnant à haut rendement.

10. Dispositif de simulation de réponse en signal d'un amplificateur non-linéaire présentant un effet de mémoire, le dispositif comportant :

   - un module (MNLSM, MM) de calcul de la réponse (y) d'un amplificateur non-linéaire à un signal monoporteuse, le module comportant :

      - au moins un filtre direct ($P_0$, $Q_0$, J1) ayant une fonction de transfert établie à partir de caractéristiques (P, Q) de conversion amplitude/amplitude (C[A]) et de conversion amplitude/déphasage ($\Phi$[A]), mesurées réellement sur l'amplificateur, chaque fonction de transfert directe étant établie avec un signal monoporteuse ($f_o$) prenant différentes amplitudes (A',A"),

   caractérisé en ce que le dispositif comporte :

   - des moyens de génération d'harmoniques (Harm) en réponse à un signal multi-porteuses ($f_{-1}$, $f_1$),
   - au moins un filtre (IMF, CF, J2, J0) de modulation de la réponse (y, $Y_{010}$) du module (MNLSM, MM) de calcul, le filtre de modulation ayant une fonction de transfert (E[f,H], F[f,H]) établie à partir de caractéristiques de distorsions de modulation d'amplitude mesurées réellement sur l'amplificateur, chaque fonction de transfert de modulation étant établie avec des signaux multi-porteuses ($f_{-1}$,$f_1$).

11. Dispositif selon la revendication 10 caractérisé en ce que le module comporte en outre :

   - au moins un correcteur (Gp[f]) en fréquence pondérant la fonction de transfert d'un filtre direct ($P_O$[A], $Q_O$[A]), chaque correcteur ayant une fonction de correction établie à partir de caractéristiques de conversion mesurées sur l'amplificateur à différentes fréquences ($f_0$-, $f_0$ , $f_0$+) de signal monoporteuse.

12. Dispositif selon la revendication 10 ou 11, caractérisé en ce que les moyens de génération d'harmoniques comportent un module de décomposition de Fourier (FFT) d'un signal en composantes (A, B, M) fréquentielles.

13. Dispositif selon l'une des revendications 10 à 12, caractérisé en ce que les moyens de génération d'harmoniques (Harm) comportent un module combinatoire calculant les combinaisons de fréquence ($2f_{-1}$-$f_1$,$2f_1$-$f_{-1}$) de composantes d'intermodulation ($f_{-3}$, $f_3$).

14. Dispositif selon l'une des revendications 10 à 13, caractérisé en ce que les moyens de génération d'harmoniques comportent un module (Squa) normatif calculant une valeur efficace d'amplitude de signal.

15. Dispositif selon l'une des revendications 10 à 14, caractérisé en ce que le filtre (IMF) de modulation a une fonction de transfert (E[f,H]) établie à partir de caractéristiques de réjection (C1/C3) de composantes d'intermodulation, de sorte que des composantes d'intermodulation ($f_{-3}$, $f_3$) d'amplitude ($C_{-3}$, $C_3$) calculée par le filtre de modulation (IMF) sont ajoutées à la réponse (y) du module de calcul lorsque l'amplification d'un signal multi-porteuses ($f_{-1}$, $f_1$) est simulée par le dispositif.

16. Dispositif selon l'une des revendications 10 à 15, caractérisé en ce qu'il comporte en outre un filtre de correction (CF) de la réponse du module de calcul (MM), le filtre ayant une fonction de transfert (F) établie à partir de caractéristiques d'interaction (C1, C-1) de porteuses, de sorte que l'amplitude (C-1) d'une porteuse ($f_{-1}$) fournie par le module de calcul (MM) est corrigée par le filtre de correction (CF) lorsque l'amplification d'un signal multi-porteuses ($f_{-1}$, $f_1$) est simulée par le dispositif.

17. Dispositif selon l'une des revendications 10 à 16, caractérisé en ce qu'il est appliqué à la simulation de réponse en signal d'un amplificateur hyperfréquence fonctionnant à haut rendement.

## FIG.1

## FIG.2

## FIG.3

## FIG.4

*FIG.5*

*FIG.6*

*6A*

*6B*

# FIG.7

# FIG.8

EP 0 896 426 A1

# FIG.9

# FIG.10

25

*FIG.11*

*FIG.12*

*FIG.13*

*FIG.14*

*FIG.15*

27

# FIG.16

# FIG.17

## FIG.18

## FIG.19

19A

19B

FIG.20

# FIG.21

# FIG.22

# FIG.23

# FIG.24

# FIG.25

*FIG.26*

Start ──── 210

Read Dat
-Points AP       p=0
-N
-Files P/I       f=0
-df
-Points P/I      i=0
-BU
──── 220

Read AP ──── 230

Dvlpt J0,J1 ──── 240   ⟹ α

f = f+1 ──── 250

Read P/I ──── 260

i = i+1 ──── 270

Calc. y ──── 280

Calc. C1',C3',C5'
C-1',C-3',C-5'
L⁺,L⁻
290 ──── 
⟹ E
⟹ F

297
no ──── i=points P/I
?

yes

298
no ──── f=files P/I
?

yes

End ──── 299

33

**Office européen des brevets**

## RAPPORT DE RECHERCHE EUROPEENNE

Numéro de la demande

EP 98 40 1958

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| Y | BOSCH W ET AL: "MEASUREMENT AND SIMULATION OF MEMORY EFFECTS IN PREDISTORTION LINEARIZERS" IEEE TRANSACTIONS ON MICROWAVE THEORY AND TECHNIQUES, vol. 37, no. 12, 1 décembre 1989, pages 1885-1890, XP000173168 * le document en entier * --- | 1-3,5 | H03F1/32 |
| Y | CARDINAL J -S ET AL: "A NEW ADAPTIVE DOUBLE ENVELOPE FEEDBACK (ADEF) LINEARIZER FOR SOLIDSTATE POWER AMPLIFIERS" IEEE TRANSACTIONS ON MICROWAVE THEORY AND TECHNIQUES, vol. 43, no. 7, PART 01, 1 juillet 1995, pages 1508-1515, XP000514134 * page 1508 - page 1515 * --- | 1-3,5 | |
| A | GHADERI M ET AL: "FAST ADAPTIVE POLYNOMIAL I AND Q PREDISTORTER WITH GLOBAL OPTIMISATION" IEE PROCEEDINGS: COMMUNICATIONS, vol. 143, no. 2, 1 avril 1996, pages 78-86, XP000592638 --- | 1-15 | DOMAINES TECHNIQUES RECHERCHES (Int.Cl.6)<br><br>H03F |
| A | KARAM G ET AL: "IMPROVED DATA PREDISTORTION USING INTERSYMBOL INTERPOLATION" WORLD PROSPERITY THROUGH COMMUNICATIONS, BOSTON, JUNE 11 - 14, 1989, vol. VOL. 1, no. -, 11 juin 1989, pages 286-291, XP000075470 INSTITUTE OF ELECTRICAL AND ELECTRONICS ENGINEERS * le document en entier * --- | 1,10 | |

-/--

Le présent rapport a été établi pour toutes les revendications

| Lieu de la recherche | Date d'achèvement de la recherche | Examinateur |
|---|---|---|
| LA HAYE | 2 novembre 1998 | Tyberghien, G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.............................................................................
& : membre de la même famille, document correspondant

EPO FORM 1503 03.82 (P04C02)

**Office européen
des brevets**

**RAPPORT DE RECHERCHE EUROPEENNE**

Numéro de la demande

EP 98 40 1958

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US 5 579 342 A (CROZIER STEWART N) 26 novembre 1996 * colonne 3, ligne 31 - colonne 8, ligne 8; figures 1-7 * ----- | 1,10 | |

|  |  | DOMAINES TECHNIQUES RECHERCHES (Int.Cl.6) |
|---|---|---|

Le présent rapport a été établi pour toutes les revendications

| Lieu de la recherche | Date d'achèvement de la recherche | Examinateur |
|---|---|---|
| LA HAYE | 2 novembre 1998 | Tyberghien, G |